# EUROPEAN PATENT APPLICATION

(11) **EP 4 141 932 A2**
(43) Date of publication of application: **01.03.2023**
(21) Application number: 22192896.3
(22) Date of filing: 30.08.2022
(51) Int. Cl.: H01L 27/02, H01L 27/118

(54) **STANDARD CELL STRUCTURE**

(30) Priority: 31.08.2021 US 202163238826 P
(71) Applicant: Invention And Collaboration Laboratory Pte. Ltd., Singapore 068914 (SG)
(72) Inventor: LU, Chao-Chun, 30078 Hsinchu (TW); CHUEH, Juang-Ying, 30078 Hsinchu (TW); HUANG, Li-Ping, 30078 Hsinchu (TW)
(74) Representative: Krauns, Christian

(57) **Abstract**

A standard cell includes a plurality of transistors, a set of contacts coupled to the plurality of transistors, at least one input line electrically coupled to the plurality of transistors, an output line electrically coupled to the plurality of transistors, a VDD contacting line electrically coupled to the plurality of transistors and a VSS contacting line electrically coupled to the plurality of transistors. As a minimum feature size (λ) of the standard cell gradually decreases from 22nm, an area size of the standard cell in terms of λ² is the same or substantially the same.

## Description

### BACKGROUND OF THE DISCLOSURE

### Background of the Invention

### 1. Field of the Disclosure

The present invention relates to a semiconductor device in a monolithic semiconductor die, and particularly to an optimized standard cell built in a monolithic semiconductor die based on integrated scaling and stretching platform which can effectively shrink a size of logic circuits in a monolithic semiconductor die without shrinking the minimum feature size.

### 2. Description of the Related Art

Improvement in integrated circuit performance and cost has been achieved largely by process scaling technology according to Moore's Law, but the process variations in transistor performance with miniaturization down to the 28 nm (or lower) manufacture process is a challenge. Especially, logic circuit scaling for increased storage density, reduction in operating voltage (Vdd) for lower stand-by power consumption, and enhanced yield necessary to realize larger-capacity logic circuit become increasingly difficult to achieve.

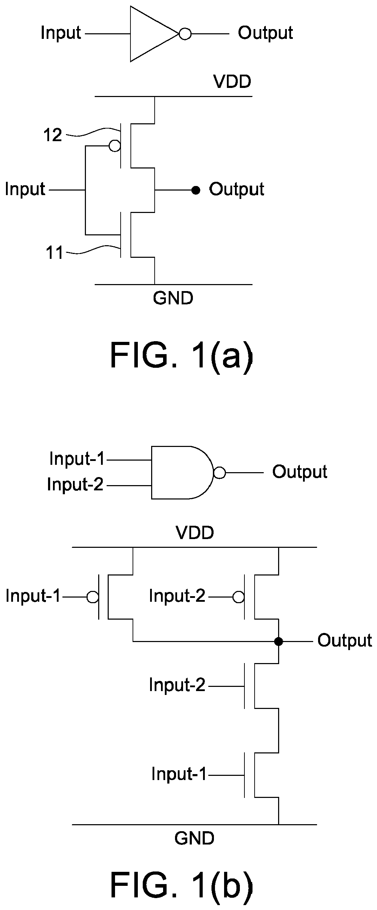

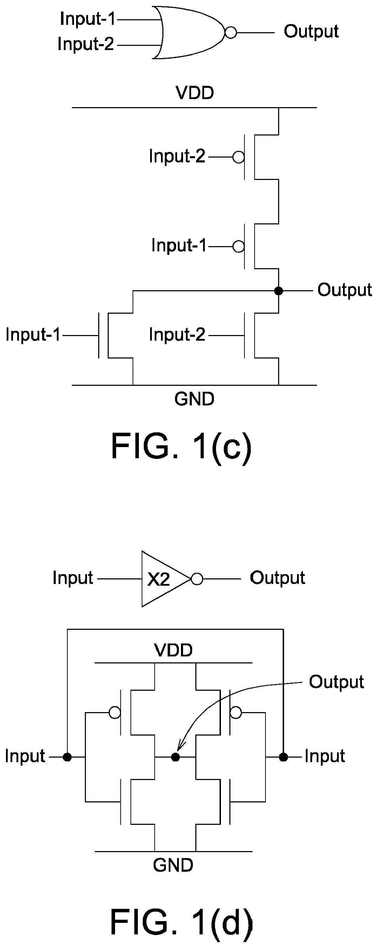

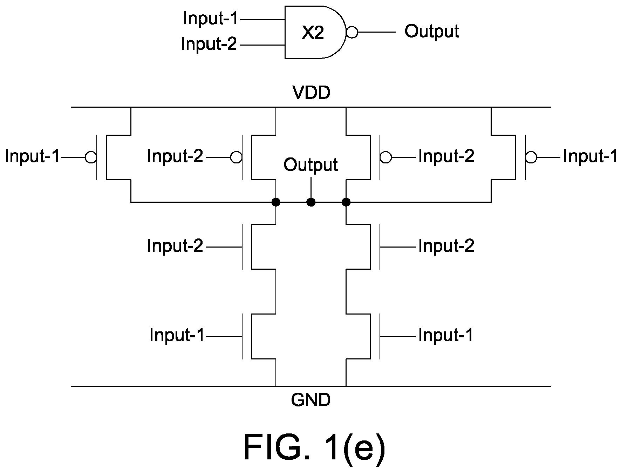

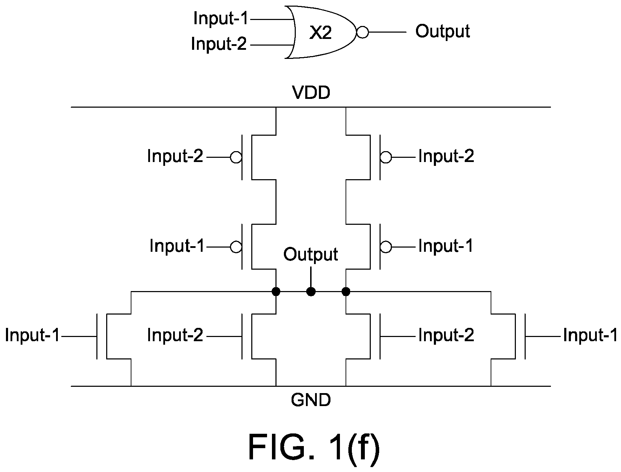

Standard cells are commonly used and basic elements in logic circuit. The standard cell may comprise basic logical function cells (such as, an inverter cell, a NOR cell, and a NAND cell, inverter cell×2, NOR cell×2, and NAND cell×2) as shown in FIG.1(a) to FIG.1(f). However, even miniaturization of the manufacture process down to the 22 nm or lower (so called, "minimum feature size", "λ", or "F"), due to the interference among the size of the contacts and layouts of the metal wires, the total area of the standard cell represented by λ² or F² dramatically increases when the minimum feature size decreases.

Some of the reasons for the dramatically increase of the total area of the standard cell when the minimum feature size decreases could be described as follows. The traditional standard cell, to take the inverter as shown in FIG.1(a) as an example, is connected by using multiple interconnections, which has its first interconnection layer M1 to connect the diffusion-level (the Source-region and the Drain-region) of the transistors. There is a need to increase a second interconnection layer M2 and/or a third interconnection layer M3 for facilitating signal transmission (such as the Input or the Output) without enlarging the die size by only using M1, then a structure Via-1, which is composed of some types of the conductive materials, is formed for connecting M2 to M1. Thus, there is a vertical structure which is formed from the Diffusion through a Contact (Con) connection to M1, i.e. "Diffusion-Con-M1". Similarly, another structure to connect the Gate through a Contact structure to M1 can be formed as "Gate-Con-M1".

Additionally, if a connection structure is needed to be formed from an M1 interconnection through a Via1 to connect to an M2 interconnection, then it is named as "M1-Via1-M2". A more complex interconnection structure from the Gate-level to the M2 interconnection can be described as "Gate-Con-M1-Via1-M2". Furthermore, a stacked interconnection system may have an "M1-Via1-M2-Via2-M3" or "M1-Via1-M2-Via2-M3-Via3-M4" structure, etc. Since the gate in two access transistors (the NMOS transistor and the PMOS transistor of the inverter as shown in FIG.1(a)) shall be connected to the Input which will be arranged in the second interconnection layer M2, in the traditional invertor such metal connections must go through interconnection layer M1 first. That is, the state-of-the-art interconnection system in inverter may not allow the Gate directly connect to M2 without bypassing the M1 structure. As results, the necessary space between one M1 interconnection and the other M1 interconnection will increase the die size and in some cases the wiring connections may block some efficient channeling intention of using M2 directly to surpass M1 regions. In addition, there is difficult to form a self-alignment structure between Via1 to Contact and at the same time both Via1 and Contact are connected to their own interconnection systems, respectively.

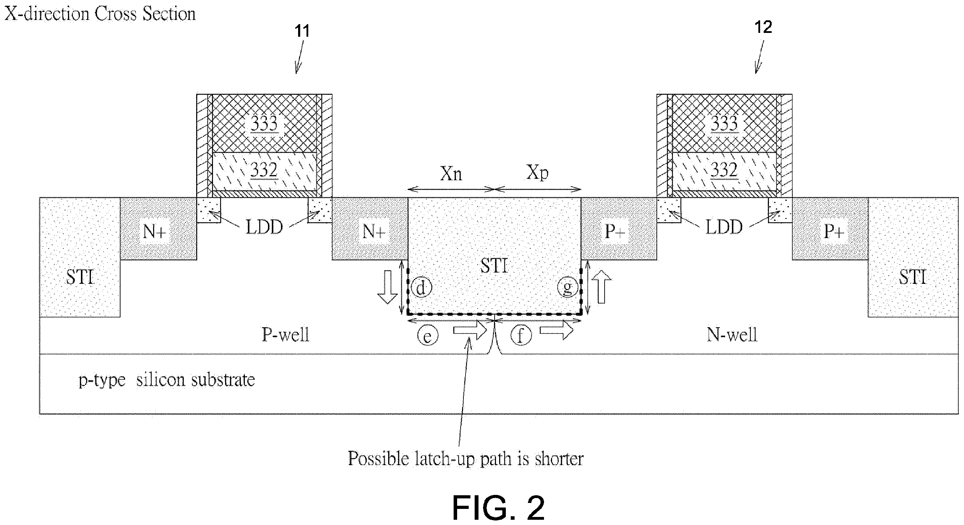

Additionally, in traditional standard cell (of the inverter as shown in FIG. 1(a)), at least there are one NMOS transistor 11 and one PMOS transistor 12 located respectively inside some adjacent regions (such as n-well and p-well) of p-substrate and which have been formed next to each other within a close neighborhood, a parasitic junction structure called n+/p/n/p+ parasitic bipolar device is formed with its contour starting from the n+ region of the NMOS transistor 11 to the p-well to the neighboring n-well and further up to the p+ region (p-well) of the PMOS transistor 12, as shown in FIG.2. There are significant noises occurred on either n+/p junctions or p+/n junctions, an extraordinarily large current may flow through this n+/p/n/p+ junction abnormally which can possibly shut down some operations of CMOS circuits and to cause malfunction of the entire chip. Such an abnormal phenomenon called Latch-up is detrimental for CMOS operations and must be avoided.

One way to increase the immunity to Latch-up which is certainly a weakness for CMOS is to increase the distance from n+ region to the p+ region. Thus, the increase of the distance from n+ region to the p+ region to avoid Latch-up issue will also enlarge the size of the standard cell.

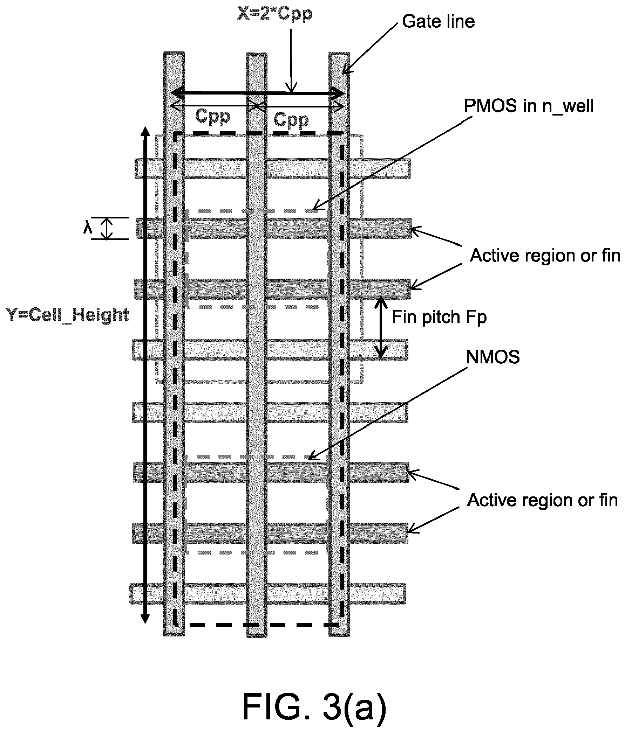

FIG.3(a) shows the "stick diagram" representing the layout and connection among PMOS and NMOS transistors of one semiconductor company's (Samsung) 5nm (UHD) standard cell. The stick diagram just includes active regions (horizontal red lines) and gate lines (vertical blue line). Hereinafter, the active region could be named as "fin". Of course, there are still lots of contacts, on one hand directly coupled to the PMOS and NMOS transistors, and on the other hand, coupled to the input terminal, the output terminal, high level voltage Vdd, and low level voltage VSS (or ground "GND"), etc. Especially, each transistor includes two active regions or fins (marked by dark red) to form the channel of the transistor, such that the W/L ratio could be maintained within an acceptable range. The area size of the inverter cell is equal to XxY, wherein X=2xCpp, Y=Cell_Height, Cpp is the distance of Contact to Poly Pitch(Cpp). It is noticed that, some active regions or fins (marked by light red, called "dummy fins") are not utilized in PMOS/NMOS of this standard cell, the potential reason of which is likely related to the latch-up issue between the PMOS and NMOS. Thus, the latch-up distance between the PMOS and NMOS in FIG. 3(a) is 3×Fp-λ (e.g., = 14λ), wherein Fp is the fin pitch (e.g., =5λ).

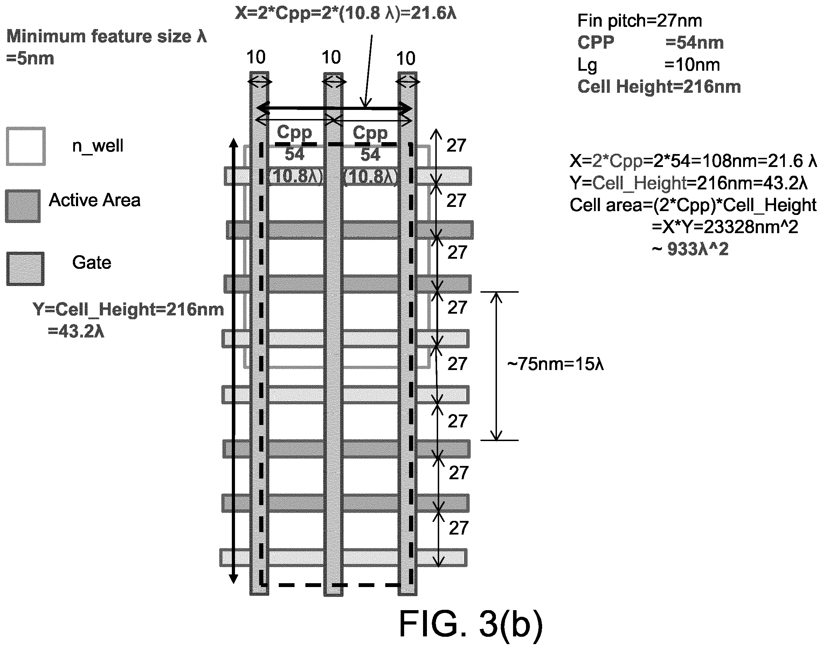

Based on the available data regarding Cpp (54nm) and Cell_Height (216 nm) in the Samsung 5nm (UHD) standard cell, the cell area can be calculated by XxY equal to 23328nm² (or 933.12λ², wherein Lambda (λ) is the minimum feature size as 5nm). FIG. 3(b) illustrates the Samsung 5nm (UHD) standard cell and the dimensions thereof. As shown in FIG. 3(b), the latch-up distance between PMOS and NMOS is around 15λ, Cpp is 10.8λ, and Cell_Height is 43.2λ.

Furthermore, the publicly available information regarding Cpp and Cell_Height for different process technology node (or minimum feature size) is shown in the following table:

| TSMC | 5 | 7 | 10 | 16 |
|---|---|---|---|---|
| Cpp (nm) | 50 | 57 | 66 | 90 |
| Cell Height (nm) | 180 | 240 | 360 | 576 |

| Samsung | 5 | 7 | 10 | 14 |
|---|---|---|---|---|
| Cpp (nm) | 54 | 54 | NA | 78.3 |
| Cell Height (nm) | 216 | 243 | NA | 576 |

| Intel | 10 | 14 | 22 | 22 |
|---|---|---|---|---|
| Cpp (nm) | 54 | 70 | 90 | 108 |
| Cell Height (nm) | 272 | 399 | 840 | 540 |

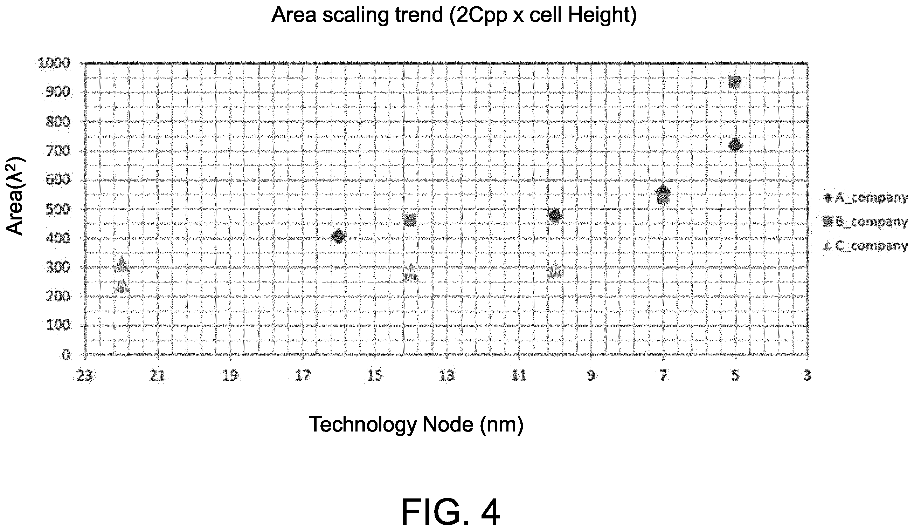

Using the above table, the scaling trend regarding area size (2 × Cpp × Cell_Height) vs. different process technology node for three foundries could be shown in FIG. 4. As the technology node decreases (such as, from 22nm down to 5nm), it is clear that the conventional standard cell (2xCppxCell_Height) area size in term of λ² increases dramatically. In the conventional standard cell, the smaller the process node, the higher the area size in term of λ². Such dramatic increase may be caused by the difficulty to proportionally shrink the size of gate contact/source contact/drain contact as A decreases, the difficulty to proportionally shrink the latch-up distance between the PMOS and NMOS, and the interference in metal layers as A decreases.

Thus, there is a need to propose a new standard cell structure which could solve the above-mentioned problems.

### SUMMARY OF THE DISCLOSURE

One embodiment of the present disclosure is to provide a standard cell, wherein the standard cell includes a plurality of transistors, a set of contacts coupled to the plurality of transistors, at least one input line electrically coupled to the plurality of transistors, an output line electrically coupled to the plurality of transistors, a VDD contacting line electrically coupled to the plurality of transistors and a VSS contacting line electrically coupled to the plurality of transistors. Wherein as a minimum feature size (A) of the standard cell gradually for different technology nodes, such as decreases from 22nm to other, an area size of the standard cell in terms of λ² is the same or substantially the same.

According to one aspect of the present disclosure, wherein the standard cell can be (but not limited to) an inverter cell, a NAND cell, or a NOR cell.

According to one aspect of the present disclosure, the standard cell further includes a metal contacting line electrically coupled to a first contact of the set of contacts; wherein the first contact is not fully covered by the metal contacting line.

According to one aspect of the present disclosure, wherein a width of the metal contacting line is the same or substantially the same as that of the first contact.

According to one aspect of the present disclosure, the standard cell further includes a highly doped silicon plug formed on a portion of the first contact which is not covered by the metal contacting line, wherein the highly doped silicon plug contacts to the metal contacting line.

According to one aspect of the present disclosure, the standard cell further includes a first metal line, electrically coupled to the plurality of transistors; and a second metal line, electrically coupled to the plurality of transistors, wherein the second metal line is above the first metal line; wherein at least one of the set of contacts directly connects to the second metal line without though the first metal line.

According to one aspect of the present disclosure, wherein the at least one of the set of contacts is a gate contact.

Another embodiment of the present disclosure is to provide a standard cell, wherein the standard cell includes a semiconductor substrate with an original surface, a plurality of transistors, a set of contacts, a first metal line and a second metal line. The set of contacts, the first metal line and the second metal line are electrically coupled to the plurality of transistors. Wherein the plurality of transistors are formed based on the semiconductor substrate, at least one of the plurality of transistors comprises a channel layer and a conductive region; and the channel layer or the conductive region is independent from the semiconductor substrate and is doped without applying an ion implantation.

According to one aspect of the present disclosure, wherein the at least one transistor includes a fin structure, the channel layer covers a first sidewall and a second sidewall of the fin structure and does not cover a top surface of the fin structure.

According to one aspect of the present disclosure, wherein the at least one transistor includes a fin structure, the channel layer comprises a top portion covering a top surface of the fin structure and a side portion covering a first sidewall and a second sidewall of the fin structure, and the top portion and the side portion are not simultaneously formed.

According to one aspect of the present disclosure, wherein the conductive region is selectively grown based on a side edge of the semiconductor substrate.

According to one aspect of the present disclosure, the standard cell further includes a trench and an isolation region. The trench is formed under the original surface of the semiconductor substrate. The isolation region is in the trench, wherein the conductive region is disposed in the trench, and a bottom surface of the conductive region is isolated from the semiconductor substrate by the isolation region.

According to one aspect of the present disclosure, wherein only one side of the conductive region is contacted to the semiconductor substrate.

According to one aspect of the present disclosure, the standard cell further includes a metal region contacting the conductive region, wherein the metal region is disposed in the trench, and a bottom surface of the metal region is isolated from the semiconductor substrate by the isolation region.

Yet another embodiment of the present disclosure provides a standard cell, wherein the standard cell includes a substrate with a well region, a plurality of transistors, a plurality of contacts, at least one input line, an output line, a VDD contacting line and a VSS contacting line. The plurality of transistors includes a first type transistor and a second transistor, wherein the first type transistor is formed within the well region and the second type transistor is formed outside the well region. The plurality of contacts are coupled to the plurality of transistors. The at least one input line is electrically coupled to the plurality of transistors. The output line is electrically coupled to the plurality of transistors. The VDD contacting line is electrically coupled to the plurality of transistors. The VSS contacting line is electrically coupled to the plurality of transistors. The first type transistor includes a first set of fin structures electrically coupled together, the second type transistor includes a second set of fin structures electrically coupled together, and a gap between the first type transistor and the second type transistor is equal to or substantially equal to 3×Fp-λ, wherein Fp is a pitch distance between two adjacent fin structures in the first type transistor and λ is a minimum feature size of the standard cell; and the pitch distance between the two adjacent fin structures in the first type transistor is between 3~5λ, such as 3λ.

According to one aspect of the present disclosure, the gap between the first type transistor and the second type transistor is between 8~12λ, such as substantially equal to 8λ.

Yet another embodiment of the present disclosure provides a standard cell, wherein the standard cell includes a plurality of transistors, a first metal line electrically coupled to the plurality of transistors and a second metal line electrically coupled to the plurality of transistors, wherein the second metal line is above the first metal line; wherein at least one of the set of contacts directly connects to the second metal line without though the first metal line.

According to one aspect of the present disclosure, wherein the at least one of the set of contacts is a gate contact.

### BRIEF DESCRIPTION OF THE DRAWINGS

The patent or application file contains at least one drawing executed in color. Copies of this patent or patent application publication with color drawing(s) will be provided by the USPTO upon request and payment of the necessary fee.

The above and other aspects of the disclosure will become better understood with regard to the following detailed description of the preferred but non-limiting embodiment(s). The following description is made with reference to the accompanying drawings:
FIG. 1(a) to FIG. 1(f) are equivalent circuit diagrams respectively illustrating the prior art basic logical function cells of inverter cell, NOR cell, and NAND cell.
FIG. 2 is a diagram illustrating a diagram illustrating a cross-sectional of a traditional NMOS and PMOS structure of a standard cell.
FIG. 3(a) is a stick diagram illustrating the layout and connection among PMOS and NMOS transistors of one semiconductor company's (Samsung) 5nm (UHD) standard cell.
FIG. 3(b) is the stick diagram illustrating the dimensions of the Samsung 5nm (UHD) standard cell as show in FIG. 3(a).
FIG. 4 is a diagram illustrating the scaling trend regarding area size (2xCppx Cell_Height) vs. different process technology node for three foundries.
FIG. 5(a) is a stick diagram illustrating the layout styles of a new inverter standard cell according to the present invention.
FIG. 5(b) is a stick diagram with dimension of the inverter standard cell as depicted in FIG. 5(a).
FIG. 5(c) to FIG. 5(f) are diagrams illustrating a series of processing layouts for forming the inverter standard cell based on FIG. 5(a) and FIG. 5(b).
FIG. 6(a) is a diagram illustrating a top view of a miniaturized metal-oxide-semiconductor field-effect transistor (mMOSFET) used in a new standard cell according to the present invention.
FIG. 6(b) is a diagram illustrating a cross-section of pad-oxide layer, the pad-nitride layer on the substrate, and the STI-oxide1 formed in the substrate.
FIG. 6(c) is a diagram illustrating the true gate (TG) and the dummy shield gate (DSG) formed on above the active region.
FIG. 6(d) is a diagram illustrating the spin-on dielectrics (SOD) being deposited, and a well-designed gate mask layer being deposited and etched.
FIG. 6(e) is a diagram illustrating the nitride layer above the dummy shield gate (DSG), the DSG, portion of the dielectric insulator corresponding to the DSG, and the p-type substrate corresponding to the DSG are removed.
FIG. 6(f) is a diagram illustrating the gate mask layer being removed, the SOD being etched, and an oxide layer being deposited to form a STI-oxide-2.
FIG. 6(g) is a diagram illustrating the oxide-3 layer being deposited and etched to form the oxide-3 spacer, the lightly Doped drains (LDDs) being formed in the p-type substrate, the nitride layer being deposited and etched back to form the nitride spacer, and the dielectric insulator being removed.
FIG. 6(h) is a diagram illustrating the intrinsic silicon electrode being grown by the selective epitaxy growth (SEG) technique.
FIG. 6(i) is a diagram illustrating the CVD-STI-oxide3 layer being deposited and etched back, the intrinsic silicon electrode being removed, and the source (n+ source) and the drain (n+ drain) of the mMOSFET being formed.
FIG. 6(j) is a diagram illustrating the oxide spacer being deposited and etched to form the contact-hole openings.
FIG. 6(k) is a diagram illustrating a layer of SOD is deposited to fill the vacancies on the substrate, and use CMP to make the surface flat.
FIG. 6(l) is the top view of the FIG. 6(k).
FIG. 6(m) is a diagram illustrating the photo resistance layer formed over the structure in FIG. 6(l).
FIG. 6(n) is a diagram illustrating an anisotropic etching technique to remove the Nitride-cap layer within the exposed gate extension region to reveal the conductive Metal-gate layer.
FIG. 6(o) is a diagram illustrating the photo resistance layer and the SOD layers being removed to form opening regions on top of both the source region and the drain region, and the spacers being formed.
FIG. 6(p) is the top view of the FIG. 6(o).
FIG. 6(q) is a diagram illustrating the layer of Metal-1 interconnection networks being formed.
FIG. 6(r) is the top view of the FIG. 6(q), in which the gate is connected to the source region through the Metal-1 layer.
FIG. 7(a) is a top view of the constructed phase of a mMOSFET used in a new standard cell according to another embodiment of the present disclosure.
FIG. 7(b) and FIG. 7(c) are two cross sections of the constructed phase of the transistor along cutline C7A1 and cutline C7A2 shown in FIG. 7(a), respectively.
FIG. 7(d) is a top view illustrating a structure after the second conductor pillar portion and the fourth conductor pillar portion are formed on the first conductor pillar portions and the third conductor pillar portion.
FIG. 7(e) is a cross-sectional view taken along the cutting line C7D1 as depicted in FIG. 7(d).
FIG. 7(f) is a cross-sectional view taken along the cutting line C1E2 as depicted in FIG. 7(d).
FIG. 7(g) is a top view illustrating a structure after the first conduction layer and the second dielectric sub-layer 860 are formed over the first dielectric layer according to one embodiment of the present disclosure.
FIG. 7(h) is a cross-sectional view taken along the cutting line C7G1 as depicted in FIG. 7(g).
FIG. 7(i) is a cross-sectional view taken along the cutting line C7G2 as depicted in FIG. 7(g).
FIG. 7(j) is a top view illustrating a structure after the conduction layer is formed over the over the upper dielectric layer according to one embodiment of the present disclosure.
FIG. 7(k) is a cross-sectional view taken along the cutting line C7J1 as depicted in FIG. 7(j).
FIG. 7(l) is a cross-sectional view taken along the cutting line C7J 2 as depicted in FIG. 7(j).
FIG. 8(a) is a top view of a mMOSFET used in a new standard cell according to one embodiment of the present disclosure.
FIG. 8(b) is a cross-sectional view taken along the cutting line C4B1 as depicted in FIG. 8(a).
FIG. 8(c) is a cross-sectional view taken along the cutting line C4B2 as depicted in FIG. 8(a).
FIG. 8(d) is a top view of another mMOSFET used in a new standard cell according to another embodiment of the present disclosure.
FIG. 8(e) is a cross-sectional view taken along the cutting line C8D1 as depicted in FIG. 8(d).
FIG. 8(f) is a cross-sectional view taken along the cutting line C8D2 as depicted in FIG. 8(d).
FIG. 9 is a diagram illustrating a cross section of the NMOS transistor used in a new standard cell according to another embodiment of the present disclosure.
FIG. 10(a) is a top view illustrating a combination structure of the PMOS transistor and the NMOS transistor used in a new standard cell according to one embodiment of the present embodiment.
FIG. 10(b) is a cross-sectional view of the PMOS transistor and the NMOS transistor taking along the cutline (X-axis) in FIG. 10(a).
FIG. 10(c) is a cross-sectional view of the PMOS transistor and the NMOS transistor taking along the cutline (Y-axis) in FIG. 10(a).
FIG. 11 is a diagram illustrating the comparison result among the area size of the new standard cell provided by the preset invention and that of the conventional products provided by various other companies.
FIG. 12(a) to FIG. 12(c) are top views and the corresponding equivalent circuit diagrams of the standard cells with one-single NOR cell, one-single NAND cell and Inverter cellx2 according to some embodiments of the present disclosure.
FIG. 12(d) and FIG. 12(e) are top views and the corresponding equivalent circuit diagrams of the standard cells with NOR cellx2 and NAND cellx2 according to some embodiments of the present disclosure.

### DETAILED DESCRIPTION OF THE DISCLOSURE

In currently conventional standard cell, even miniaturization of the minimum feature size or technology node is down to the 28 nm or lower, the size of transistor could not be diminished proportionally. The present invention discloses a new standard cell with a compact layout style in a monolithic semiconductor die, by adopting the new layout style the area size of the standard cell across different technology nodes can stay flat or less sensitive to the technology nodes without enlarging the Latch-up issue.

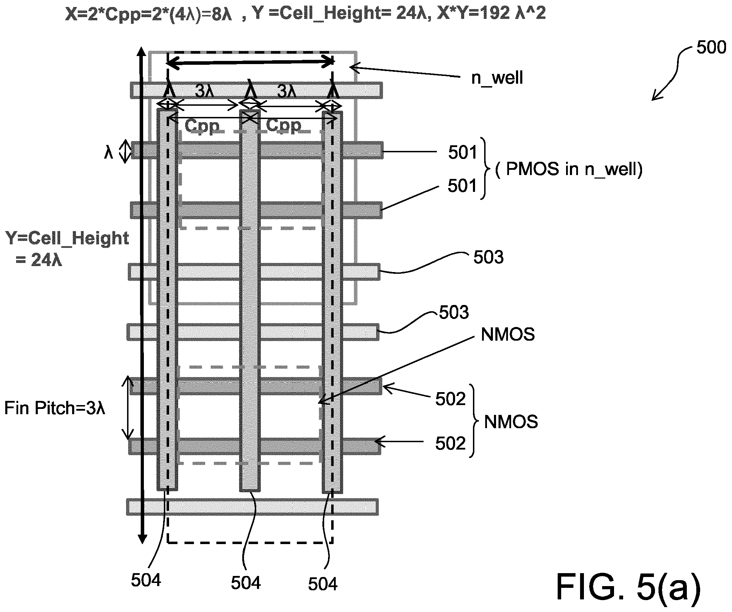

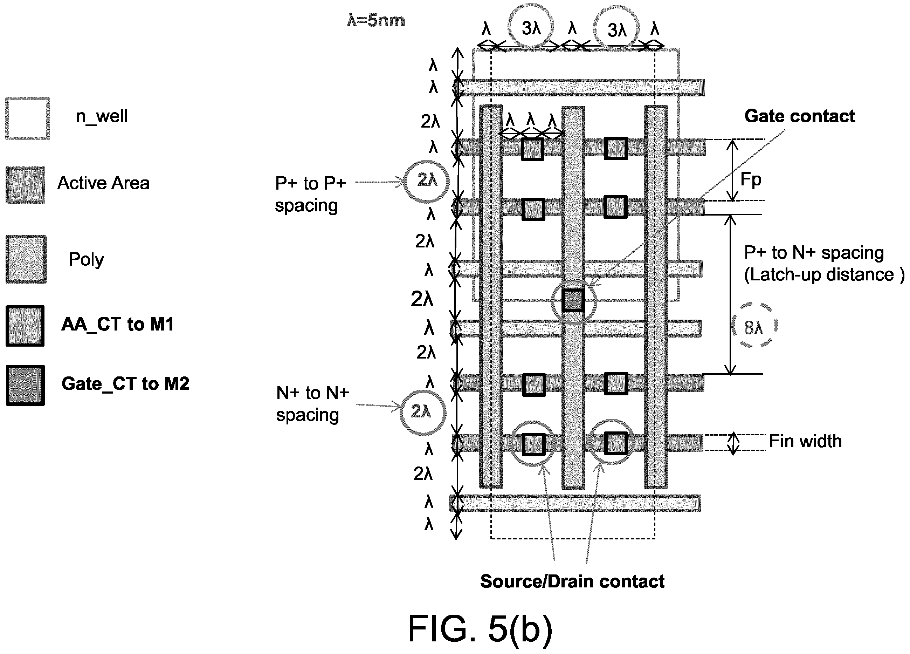

For example, FIG. 5(a) illustrates a stick diagram of a standard cell 500 according to the present invention. FIG. 5(b) is a stick diagram with dimension (in term of λ) of the inverter cell 500 according to FIG. 5(a). For purpose of describing the structure in clarity and concise, merely gate-level and diffusion level of the inverter standard cell 500 are depicted.

Wherein, the inverter standard cell 500 incudes a NMOS transistor and a PMOS transistor, wherein the PMOS transistor has a first fin structure consisting of two fins (with a pitch distance Fp of 3λ there between) formed in an n_well region of a semiconductor substrate (not shown) and a gate covering the fin structure; and the NMOS transistor has a second fin structure consisting of two fins (with a pitch distance Fp of 3λ there between) formed in an p_well region of the semiconductor substrate (bot shown) and a gate covering the second fin structure. The NMOS transistor is separated from the PMOS transistor with a gap having a distance greater than a fin pitch, and there are two dummy fins disposed between the NMOS transistor and the PMOS transistor.

The area size of the inverter standard cell 500 can achieve compact design, as a minimum feature size (λ) of the inverter standard cell 500 gradually decreases for different technology nodes (such as from 22nm to 16nm, or from 22nm to 5nm), an area size of the inverter standard cell 500 in terms of λ² is the same or substantially the same. In the present embodiment, width for active region or fin is λ, so is the width of the gate line (or Poly line), the Cpp is 4λ, the Cell_Height is 24λ, and the cell area (2xCppx Cell_Height as marked by black-dash rectangle) of the inverter standard cell 500 is 192λ².

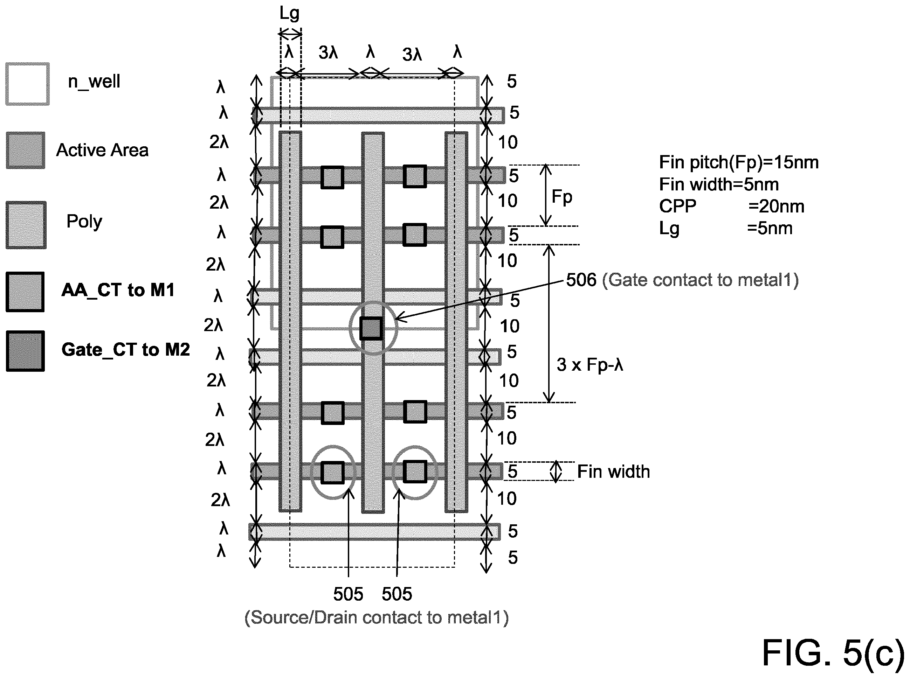

FIG. 5(c) to FIG. 5(f) are diagrams illustrating a series of processing layouts for forming the new inverter standard cell 500 based on FIG. 5(a) and FIG.5(b) when λ is set to 5nm. As shown in FIG. 5(a), a plural sets of fin structure (such as a plurality of horizontal fins) are formed on a semiconductor substrate (not shown), wherein two adjacent fins 501 formed in an n_well region of the semiconductor substrate are used as the active region the PMOS transistor; two adjacent fins 502 formed in the semiconductor substrate and adjacent to the PMOS are used as the active region of the NMOS transistor. Here two adjacent fins 503 formed in the semiconductor substrate and between the NMOS transistor and the PMOS transistor can serve as two dummy fins. In FIG. 5(c), a gap between the PMOS transistor and the NMOS transistor is equal to or substantially equal to 3xFp-Fw, wherein Fp is a fin pitch distance shown in FIG. 5(a) between two adjacent fin structures (e.g., Fp = 3λ); and Fw is the fin width of the fin structure. In this embodiment, the fin width Fw is set to λ (a minimum feature size).Thus, a gap between the PMOS transistor and the NMOS transistor is equal to or substantially equal to 3×Fp-λ (e.g., gap = 8λ).

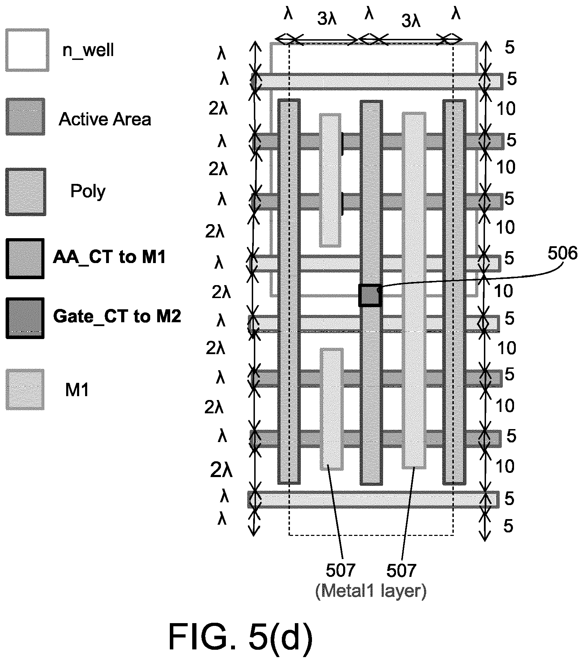

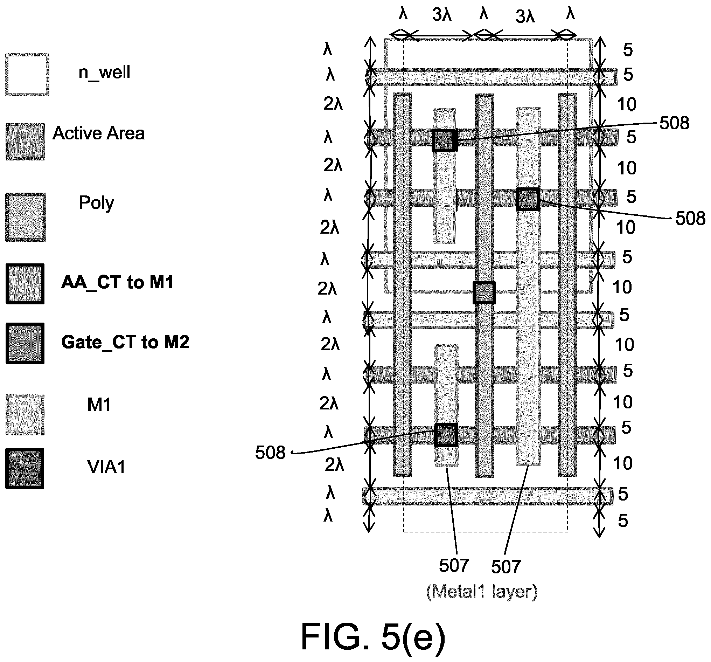

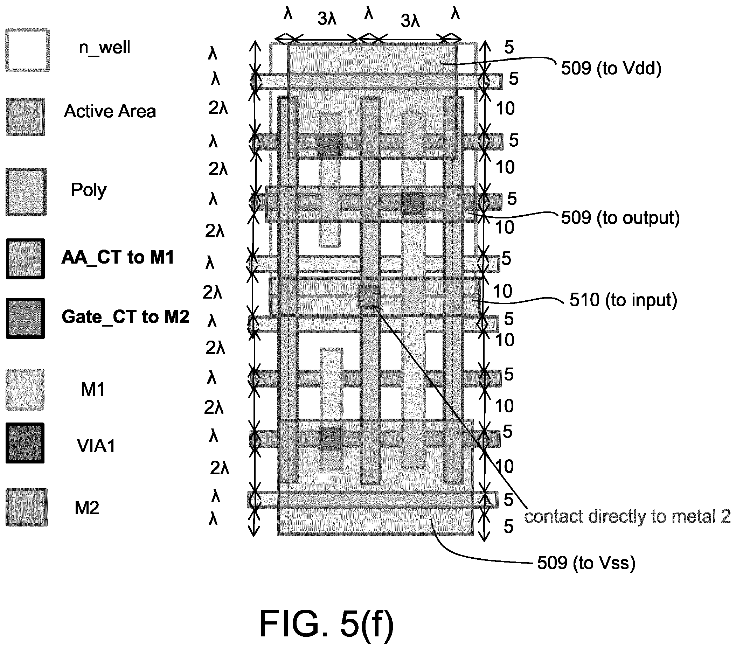

Furthermore, plural of gate lines 504 (or Poly-lines) are formed on the semiconductor substrate and straddling over the fin structures of the PMOS transistor and the NMOS transistor and the dummy fins. In the present embodiment, the gap between two gate lines or Poly lines (Cpp, marked in FIG. 5(a)) is as small as 4λ. In FIG.5(c), a plurality of source/drain contact AA_CT 505 (Opening VIA Mask layer for connecting Active Area of the source/drain region to the Metal-1 layer (M1)) and a gate contact Gate_CT 506 (Opening VIA Mask layer for directly Poly-lines to the Metal-2 layer (M2)) are formed. FIG.5 (d), a plurality of Metal-1 layers (M1) 507 (width: λ or greater) are formed to connect the plurality of the source/drain contacts 505 (AA_CT mask), however, the gat contact Gate_C 506 do not connect to the Metal-1 layers (M1) 507. In FIG.5(e), a plurality of VIA1 508 for connecting the Metal-1 layer (M1) 507 to the Metal-2 layer (M2) are formed on top of the Metal-1 layer (M1) 507. In FIG.5(f), a plurality of Metal-2 layer (M2) 509 are formed to connect the plurality of VIA 1 508 to Vdd, the output terminal and the Vss, respectively; wherein one additional Metal-2 layer (M2) 510 is formed to directly connect the gate contact Gate_C 506 to the input terminal.

The conventional standard cell may not allow the gate or source/drain directly connect to Metal-2 layer (M2) without bypassing the Metal-1 layer (M1). The present invention discloses a new standard cell structure in which the gate/source/drain could be directly connected to the Metal-2 interconnection layer without a transitional Metal-1 layer in a self-alignment way through one vertical conductive plug, as described below.

In FIG.5(a) to FIG.5(f), the meaning of the abbreviated symbols are as follows:

| M2 | The Metal-2 layer |
|---|---|
| VIA1 | The VIA Mask layer for connecting the Metal-1 layer to the Metal-2 layer |
| M1 | The Metal-1 layer |
| CT_AA to M1 | Opening VIA Mask layer for connecting AA (or Poly) to the Metal-1 layer, wherein "AA" means the active region (source or drain), and "Poly" means gate region. |
| Gate_CT to M2 | Opening VIA Mask layer for connecting AA (or Poly) directly to the Metal-2 layer |
| Poly | The Mask layer for Polysilicon Gate or Metal Gate |
| Active Area | The Mask layer for Active Area (such as drain region or source region) |
| n_well | The N-well Mask area for N-well |
| Vdd | Vdd voltage source |
| Vss | Vss voltage source |

In addition, those dimensions of the inverter standard cell 500 can be easily achieved by precisely controlling the linear dimensions of the source, the drain and the gate of the PMOS transistor and the NMOS transistor in the new inverter standard cell 500, and the linear dimension can be as small as the minimum feature size, Lambda (λ), no matter the size of the currently available technology node (or minimum feature size).

In a traditional standard cell, even miniaturization of the manufacture process is down to the 28 nm or lower (so called, "minimum feature size", "λ", or "F"), the size of a metal oxide semiconductor field effect transistor (mMOSFET) used in a standard cell could not be diminished proportionally. However, in the present embodiment, when two adjacent transistors (such as, the PMOS transistor and the NMOS transistor in FIG. 5(a)) are connected together through the drain/source, the distance between the edges of the gates of the two adjacent transistors (i.e. the latch-up distance) could be as small as 8λ. Additionally, a linear dimension for a contact hole for the source, the drain and the gate could be less than λ, such as 0.6λ~0.8λ, can be achieved within the drain area (so is within the source area and the gate area).

As shown in FIG. 5(b), each of the PMOS and the NMOS includes multiple active regions to maintain reasonable W/L ratio. The source/drain contacts AA_CT (for connection to the Metal-1 layer (M1)) could be formed in the active regions. The present invention uses a temporary Dummy-Shield-Gate (DSG) added on the Gate-Level Mask to achieve making the designed distance from the Gate Edge to the Boundary Edge between the Source Region and the Isolation Region (GEBESI) sharply by avoiding Photolithographic Misalignment Tolerances (MTP).

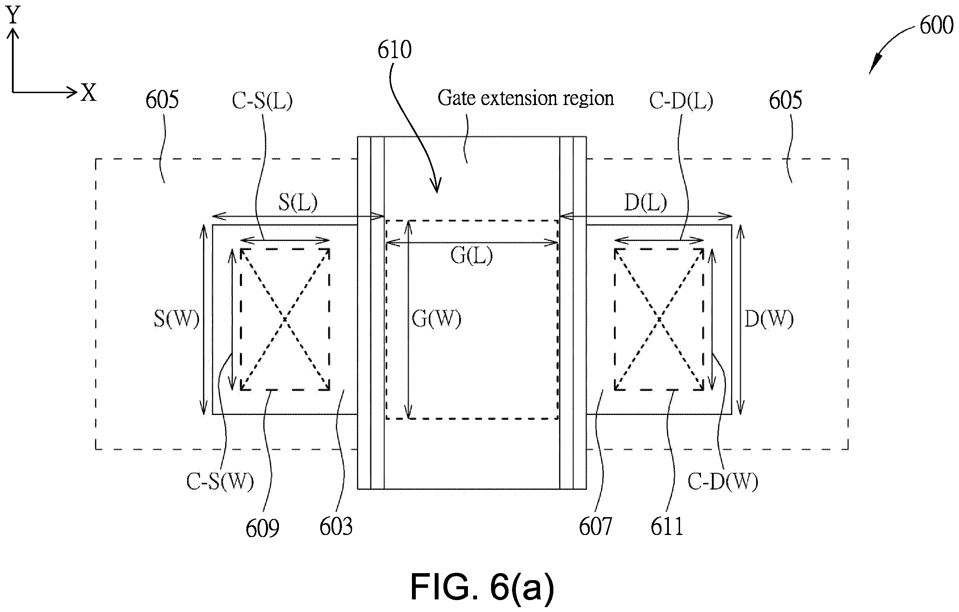

For example, FIG. 6(a) is an example of a miniaturized metal oxide semiconductor field effect transistor (mMOSFET) 600 used in a new standard cell according to one embodiment of the present invention. As shown in FIG. 6(a), the mMOSFET 600 includes: (1) a gate structure 610 has a length G(L) and a width G(W), (2) on a left-hand side of the gate structure 610, a source 603 has a length S(L) which is a linear dimension from an edge of the gate structure 610 to an edge of an isolation region 605 and a width S(W), (3) on a right-hand side of the gate structure 610, a drain 607 has a length D(L) which is a linear dimension from the edge of the gate structure 610 to the edge of the isolation region 605 and a width D(W), (4) at a center of the source 603, a contact-hole 609 formed by a self-alignment technology has length and width of an opening labeled as C-S(L) and C-S(W), respectively, and (5) similarly at a center of the drain 607, a contact hole 611 formed by the self-alignment technology has length and width of an opening labeled as C-D(L) and C-D(W), respectively. The length G(L), the length D(L), and the length S(L) could be precisely controlled as small as the minimum feature size λ. Furthermore, the length and width of an opening labeled as C-S(L) and C-S(W) or the length and width of an opening labeled as D-S(L) and D-S(W)could be less than λ, such as 0.6λ~0.8λ.

The following briefly describes the manufacture process for the aforesaid mMOSFET 600 used in the standard cell of the present invention. The detailed description for the structure of the mMOSFET 600 and the manufacture process thereof is presented in the US Patent Application No. 17/138,918, filed on Dec. 31, 2020 and entitled: "MINIATURIZED TRANSISTOR STRUCTURE WITH CONTROLLED DIMENSIONS OF SOURCE/DRAIN AND CONTACT-OPENING AND RELATED MANUFACTURE METHOD", and the whole content of the US Patent Application No. 17/138,918 is incorporated by reference herein.

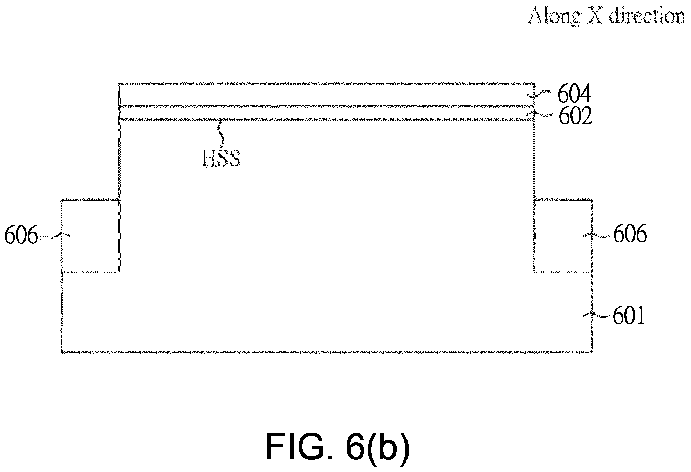

As shown in FIG. 6(b), a pad-oxide layer 602 is formed and a pad-nitride layer 604 is deposited on a substrate 601. The active region of the mMOSFET 600 is also defined and remove parts of silicon material outside the active region to create the trench structure. An oxide-1 layer is deposited in the trench structure and etched back to form a shallow trench isolation (STI-oxide1) 606 below the original horizontal surface of the silicon substrate ("HSS").

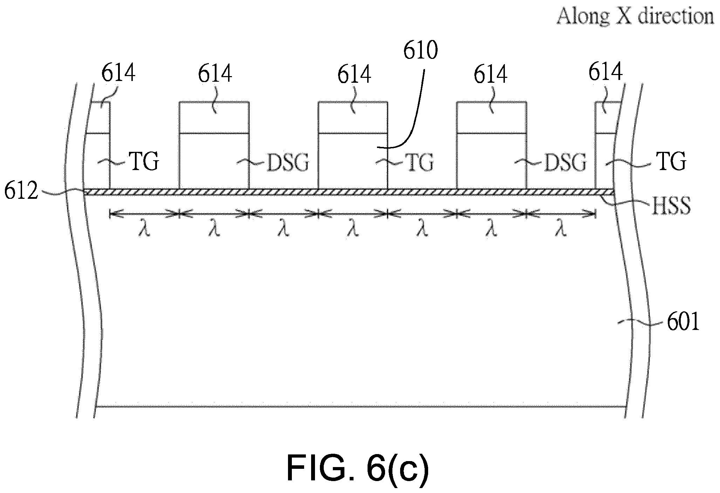

The pad-oxide layer 602 and the pad-nitride layer 604 are removed, and a dielectric insulator 612 is formed over the HSS. Then, a gate layer 610 and a nitride layer 614 are deposited above the HSS, and the gate layer 610 and the nitride layer 614 are etched to form a true gate (TG) of the mMOSFET and dummy shield gates (DSG) with a desired linear distance to the true gate. As shown in FIG. 6(c), the length of the true gate (TG) is λ, the length of the dummy shield gate (DSG) is also λ, and the distance between the edges of the true gate (TG) and the dummy shield gate (DSG) is λ as well.

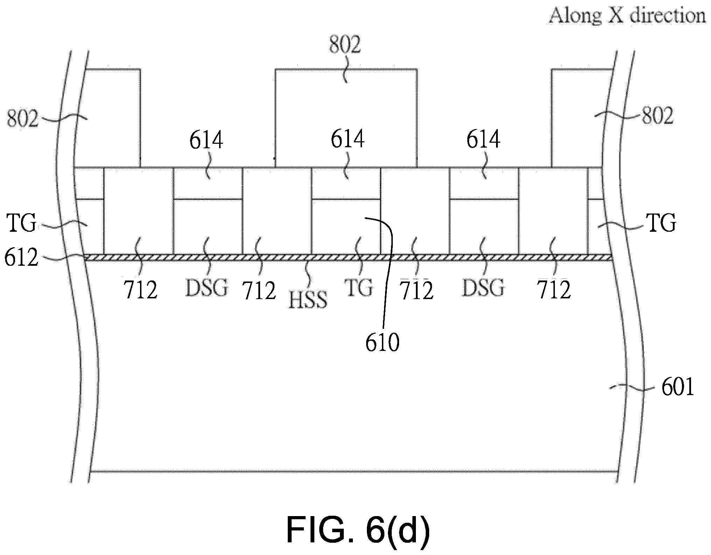

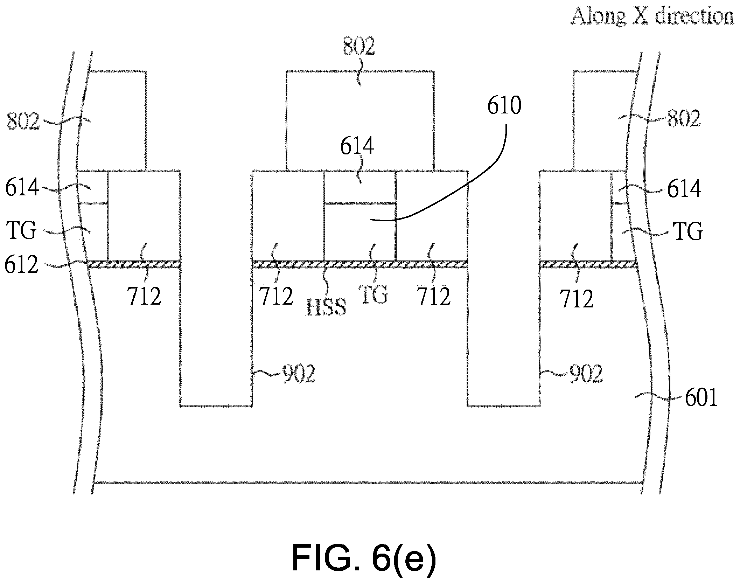

Then, deposit a spin-on dielectrics (SOD) 712, and then etch back the SOD 712. Form a well-designed gate mask layer 802 by the photolithographic masking technique, as shown in FIG. 6(d). Thereafter, utilize the anisotropic etching technique to remove the nitride layer 614 above the dummy shield gate (DSG), and remove the dummy shield gate (DSG), portion of the dielectric insulator 612 corresponding to the dummy shield gate (DSG), and the p-type substrate 601 corresponding to the dummy shield gate (DSG), as shown in FIG. 6(e).

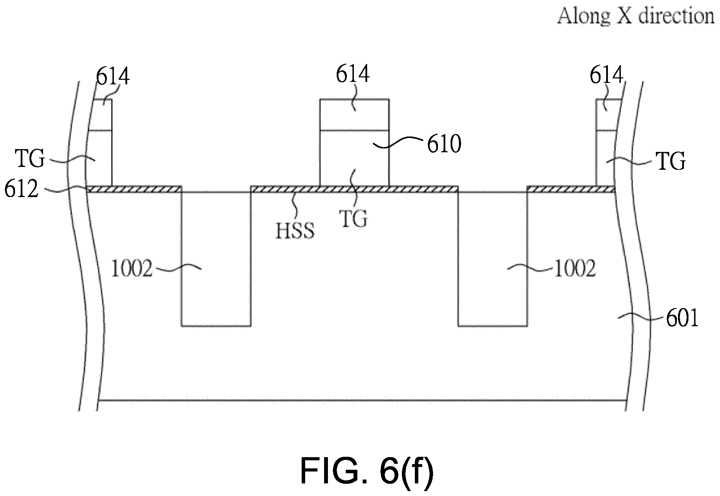

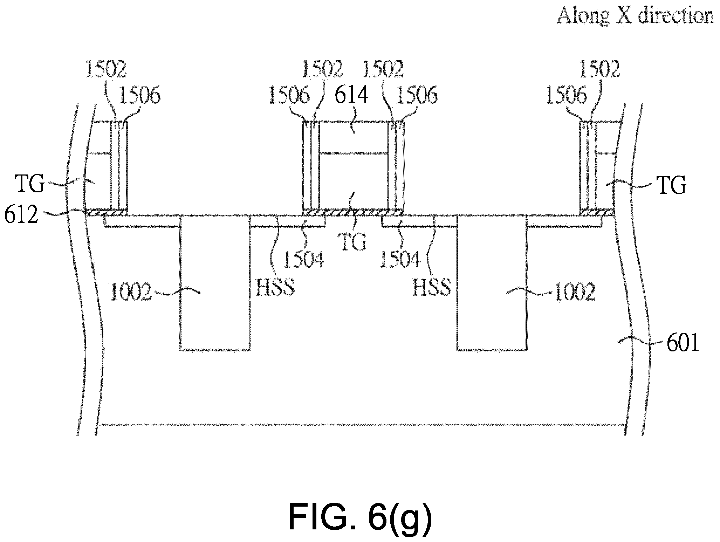

Furthermore, remove the gate mask layer 802, etch the SOD 712, and deposit a STI-oxide-2 1002 and then etch back, as shown in FIG. 6(f). Then, deposit and etch back an oxide-3 layer to form an oxide-3 spacer 1502, form the lightly Doped drains (LDDs) 1504 in the p-type substrate 601, deposit and etch back a nitride layer to form a nitride spacer 1506, and remove the dielectric insulator 402, as shown in FIG. 6(g).

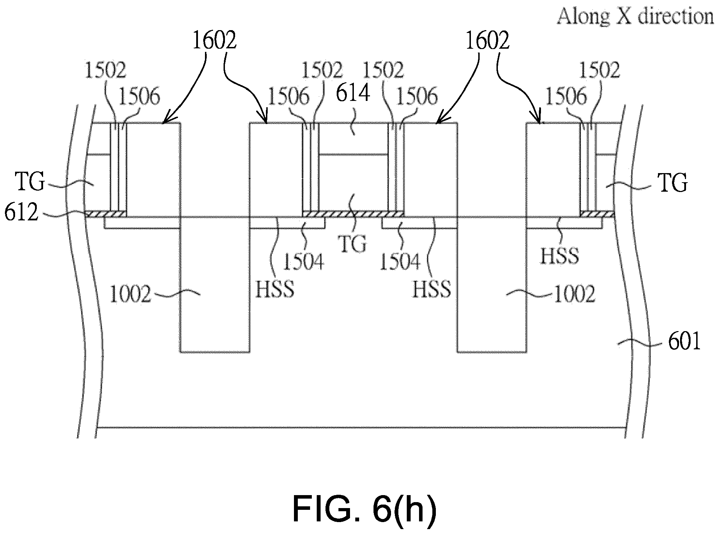

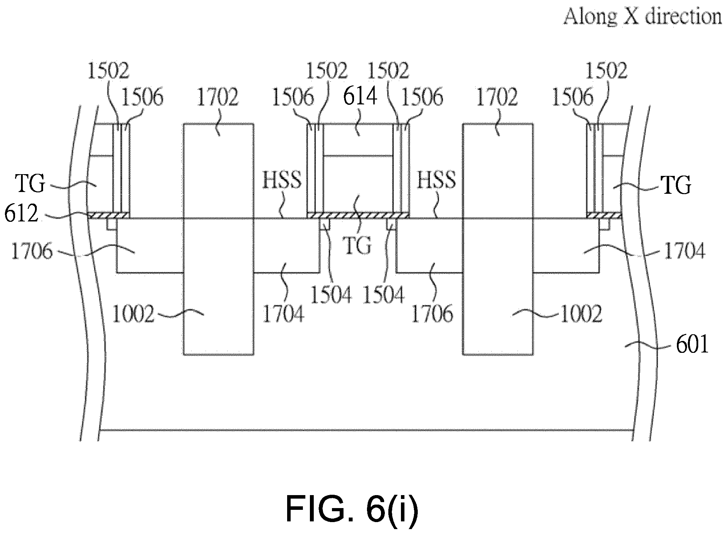

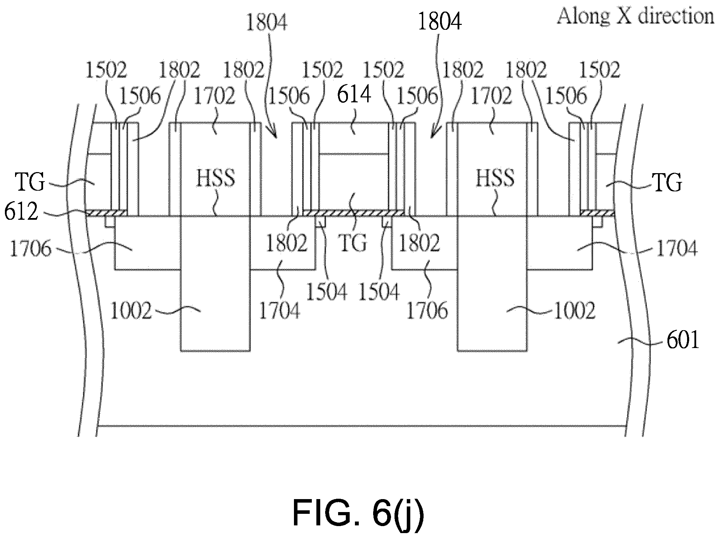

Moreover, utilize a selective epitaxy growth (SEG) technique to grow intrinsic silicon electrode 1602, as shown in FIG. 6(h). Then deposit and etch back a CVD-STI-oxide3 layer 1702, remove the intrinsic silicon 1602, and form a source region (n+ source) 1704 and a drain region (n+ drain) 1706 of the mMOSFET, as shown in FIG. 6(i). Since the source region (n+ source) 1704 and a drain region (n+ drain) 1706 are formed between the true gate (TG) and the CVD-STI-oxide3 layer 1702 the location of which is originally occupied by the dummy shield gate (DSG), thus, the length and width of the source region (n+ source) 1704 (or a drain region (n+ drain) 1706) is as small as λ. The opening of the source region (n+ source) 1704 (or a drain region (n+ drain) 1706) could be less than λ, such as 0.8λ. Such openings could be shrunk if further oxide spacer 1802 is formed, as shown in Fig. FIG. 6(j).

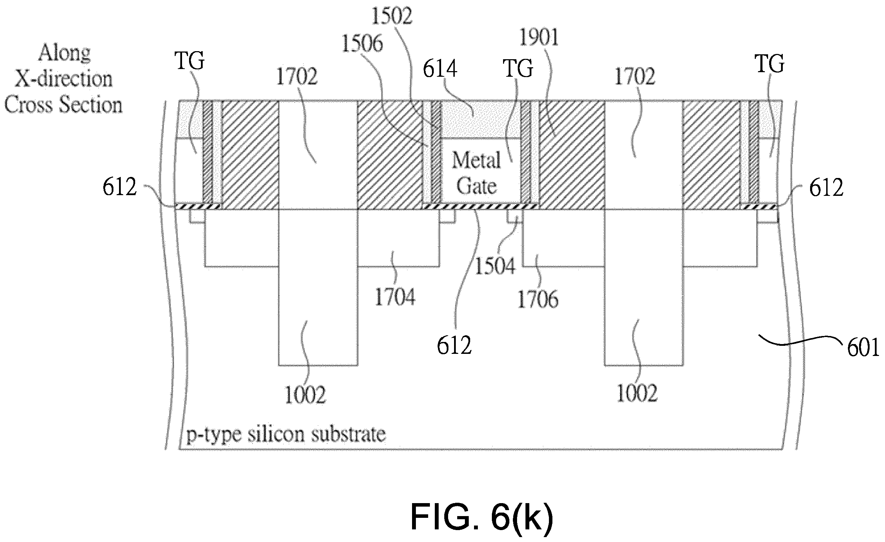

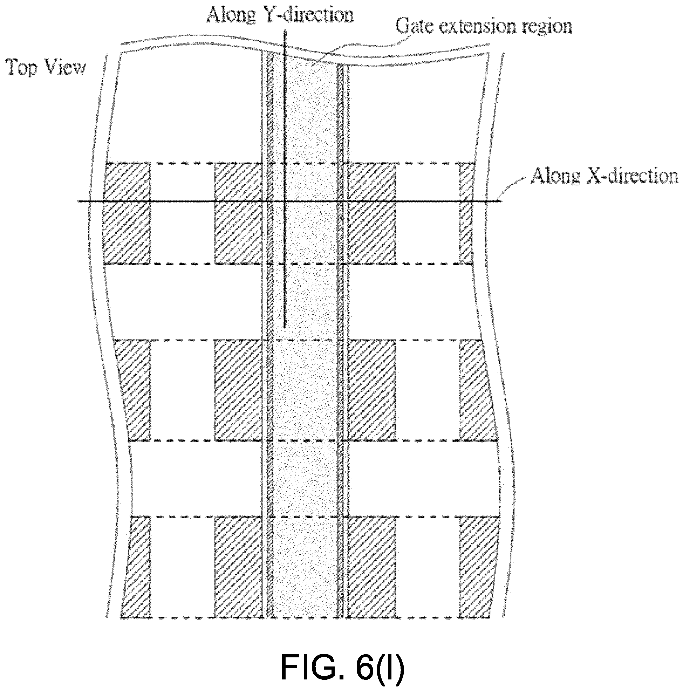

Additionally, the new standard cell makes the first metal interconnection (M1 layer) directly connect Gate, Source and/or Drain regions through self-aligned miniaturized contacts without using a conventional contact-hole-opening mask and/or a Metal-0 translation layer for M1 connections. Following FIG 6(i), a layer of SOD 1901 is deposited to fill the vacancies on the substrate, including the openings 1804 of the source region (n+ source) 1704 (or a drain region (n+ drain) 1706). Then use CMP to make the surface flat, as shown in FIG. 6(k). FIG. 6(l) is the top view of the FIG. 6(k) and shows multiple fingers in horizontal direction.

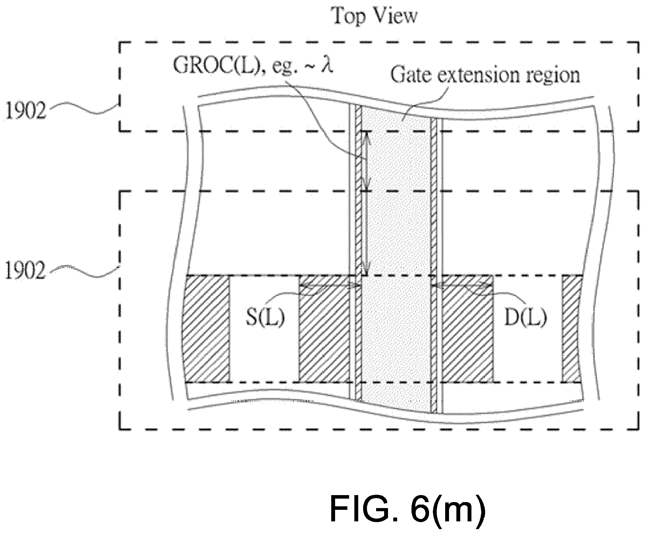

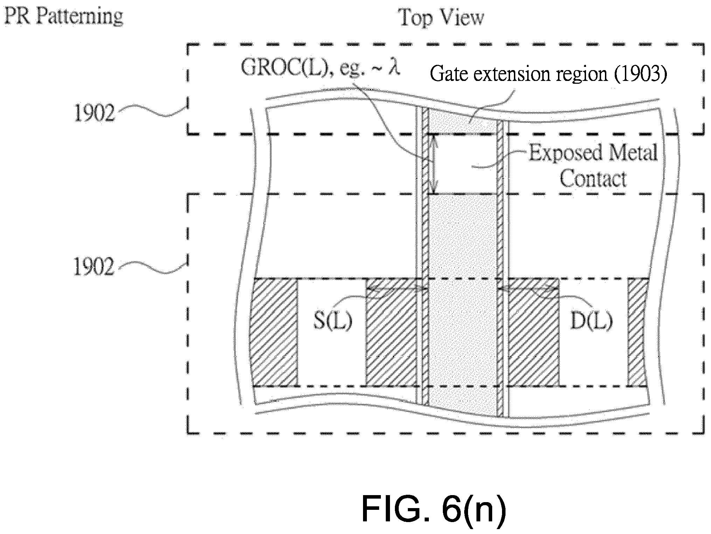

Furthermore, use a well-designed mask and carry out a photo resistance layer 1902 which results in some stripe pattern along the X-axis in FIG. 6(l) with a separate space of the length GROC(L) to expose the area of gate extension region along the Y-axis in Figure FIG. 6(l), then the result is shown as a top view in FIG. 6(m). The most aggressive design rules with GROC(L) = λ, as shown in FIG. 6(m). Then use an anisotropic etching technique to remove the Nitride-cap layer within the exposed gate extension region to reveal the conductive Metal-gate layer (as shown in FIG. 6(n)).

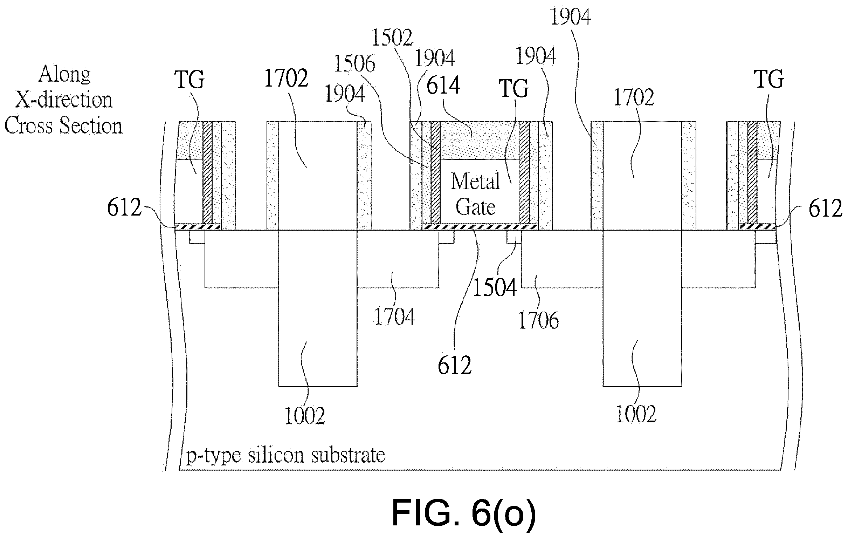

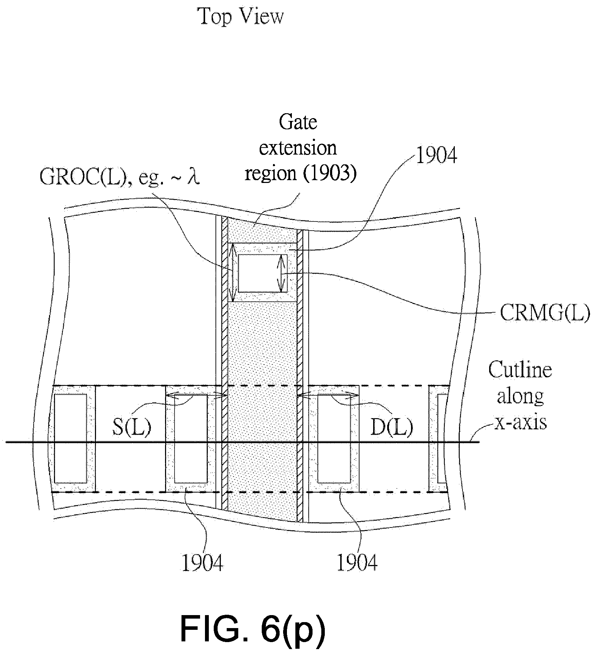

Thereafter, remove photo resistance layer 1902, and then remove the SOD layers 1901 so that those opening regions on top of both the source region 1704 and the drain region 1706 are revealed again. Then deposit a layer of oxide 1904 with well-designed thickness and then use an anisotropic etching technique to form spacers on the four sidewalls in opening regions of the source region 1704 and the drain region 1706 and the exposed gate extension region 1903. Therefore, a natural built-up contact-hole opening is formed in the exposed gate extension region, the source region 1704 and the drain region 1706, respectively. FIG. 6(o) shows the cross section of such transistor structure. FIG. 6(p) shows top view of such a transistor structure in FIG. 6(o). The vertical length CRMG(L) of the opening in the exposed gate extension region 1903 is smaller than the length GROC(L) which could be λ.

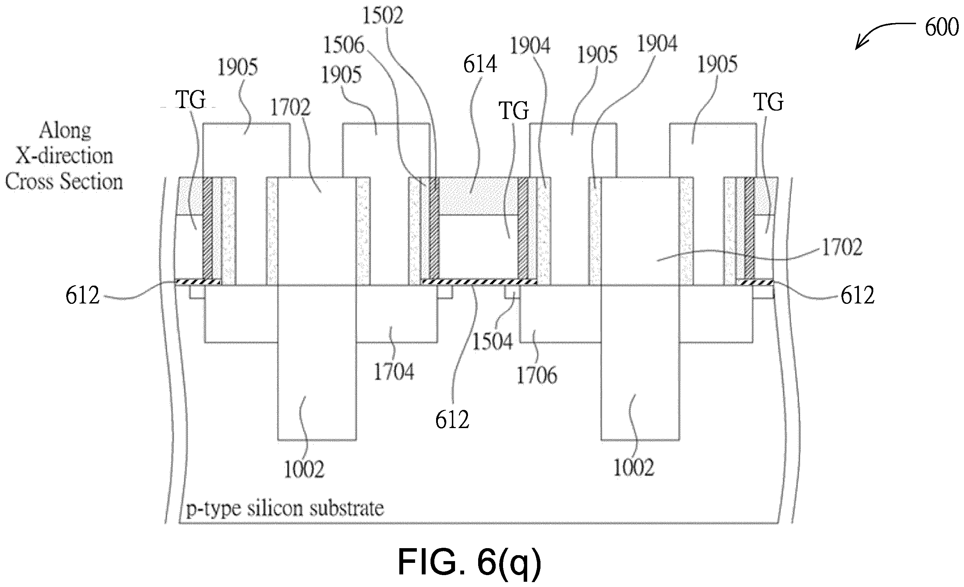

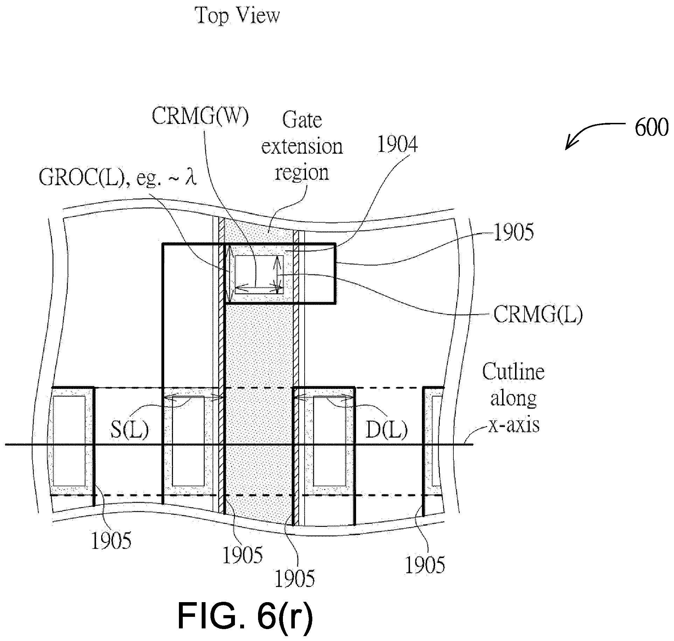

Finally, form a layer of Metal-1 1905 which has the well-designed thickness to fill in the holes of all the aforementioned contact-hole openings and result in a smooth planar surface following the topography of the wafer surface. Then use a photolithographic masking technique to create all the connections among those contact-hole openings respectively to achieve the necessary Metal-1 interconnection networks, as shown in FIG. 6(q). FIG. 6(r) is the top view of the mMOSFET 600 shown in FIG. 6(q). So this Metal-1 layer complete the tasks of achieving both the contact-filling and the plug-connection to both Gate and Source/Drain functions as well as a direct interconnection function of connecting all transistors. There is no need to use an expensive and very rigidly controlled conventional contact-hole mask and carrying on the subsequent very difficult process of drilling the contact-hole openings, especially which should be the most difficult challenges in further scaling down the horizontal geometries of billions of transistors. In addition, it eliminates making both a metal plug into the contact-hole openings and a CMP process to achieve a Metal stud with complex integrated processing step (eg. as definitely required for some leading-edge technology of creating a Metal-Zero structure).

Thereby, the size of the source/drain contact (such as the AA_CT as shown in Fig. FIG. 5(b)) could be as small as λ×λ, no matter the size of the technology node or (or minimum feature size). Similarly, gate contact (such as the Gate_CT for direct connection to the metal-2 layer (M2 as shown in Fig. FIG. 5(b)) could be formed on the gate or Poly line, and the size of the gate contact is λ×λ as well. That is, the linear dimensions of the source, the drain and the gate of the transistors (such as the PMOS transistor and the NMOS transistor in FIG. 5(a)) and the contacts thereof in the standard cell can be precisely controlled, and the linear dimension can be as small as the minimum feature size, Lambda (λ), In the present embodiment, the source/drain contact size would be bigger, such as λ (width in Y direction)×2λ (length in X direction), and the gap between two gate or Poly lines would be larger than 3λ, such as 4 or 5λ.

Moreover, as mentioned, the traditional standard cell may not allow the Gate or Diffusion directly connect to M2 without bypassing the M1 structure. The present invention discloses a new standard cell in which either Gate or Diffusion (Source/Drain) areas to be directly connected to the M2 interconnection layer without a transitional layer M1 in a self-alignment way through one vertical conductive plug being composed of Contact-A and Via1-A which are respectively formed during the construction phases of making Contact and Via1 in the other locations on the same die. As results, the necessary space between one M1 interconnection and the other M1 interconnection and blocking issue in some wiring connections will be reduced.

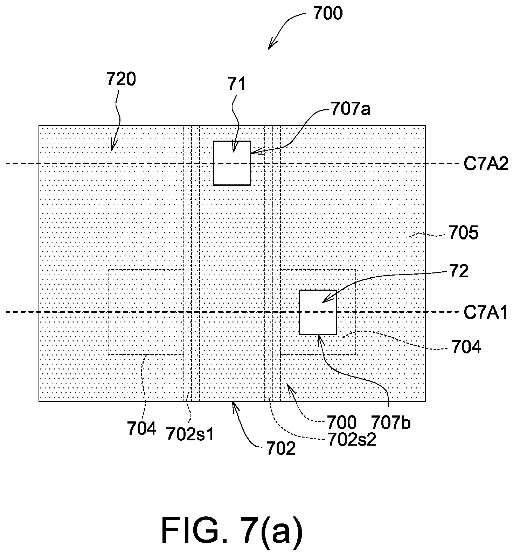

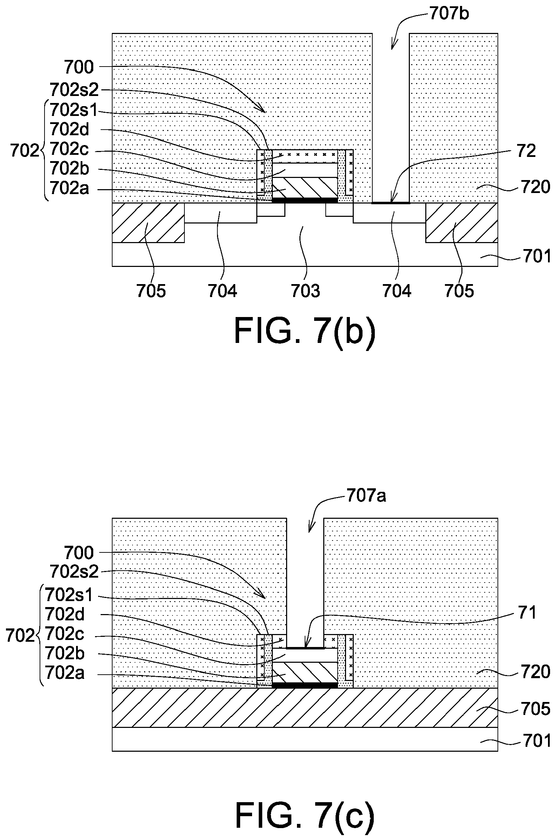

The following briefly describes a mMOSFET 700 used in the standard cell according to another embodiment of the present invention, in which the Gate and Diffusion (Source/Drain) areas is directly connected to the M2 interconnection layer without a transitional layer M1 in a self-alignment way. FIG. 7(a) is a top view of the constructed phase of the mMOSFET 700, and FIG. 7(b) and FIG. 7(c) are two cross sections of the constructed phase of the transistor along cutline C7A1 and cutline C7A2 shown in FIG. 7(a), respectively.

As shown in FIG. 7(b) and FIG.7(c), the mMOSFET 700 is formed and limited by a shallow trench isolator (STI) 705. The mMOSFET 700 has a gate terminal 702, a transistor channel region 703 beneath the gate terminal 702 and source/drain regions 704. The gate terminal 702 comprises a gate dielectric layer 702a, a gate conduction layer 702b formed over the gate dielectric layer 702a and a silicon region (or a seed region) 702c formed over the gate conduction layer 702b. The silicon region 702c can be made of polysilicon or amorphous silicon. The gate terminal 702 further includes a capping layer 702d(e.g. a nitride layer) over the top of the silicon region 702c and further includes at least one spacer (e.g., including a nitride spacer 702s1 and a thermal oxide spacer 702s2) over the sidewalls of the gate dielectric layer 702a, the gate conduction layer 702b and the silicon region 702c. The first dielectric layer 720 is formed on the semiconductor substrate 701 at least covering the active area of the mMOSFET 700 including the gate terminal 702 and the source/drain regions 704 as well as the STI 705.

A plurality of open holes (such as the open holes 707a and 707b are formed in the first dielectric layer 720 to reveal the top portion 71 of the silicon 702c region and the top portion 72 of the source/drain regions 704. In some embodiments, the open holes 707a and 707b are formed by a photolithography process to remove portions of the first dielectric layer 720 to exposed the portion the silicon region 702c and the silicon region of the drain terminal of the source/drain regions 704. In one example, each of the open holes 707a and 707b could be a size equal to a minimum feature size (e.g. a critical size of the mMOSFET 700). Of course, the size of the open holes 707a and 707b could be larger than the minimum feature size. The bottoms of the open holes 707a and 707b (i.e. the revealed top portion 71 and the revealed top portion 72) are made of materials with either polycrystalline/amorphous silicon or crystalline silicon with heavily doped concentrations having high conductivity, respectively. The exposed silicon region 702c of the gate terminal and the exposed silicon region of the source/drain terminal are seed regions for the selective epitaxy growth technique (SEG) to grow pillars based on the seed regions.

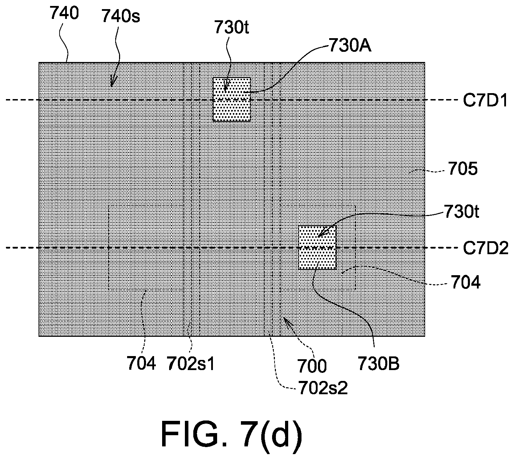

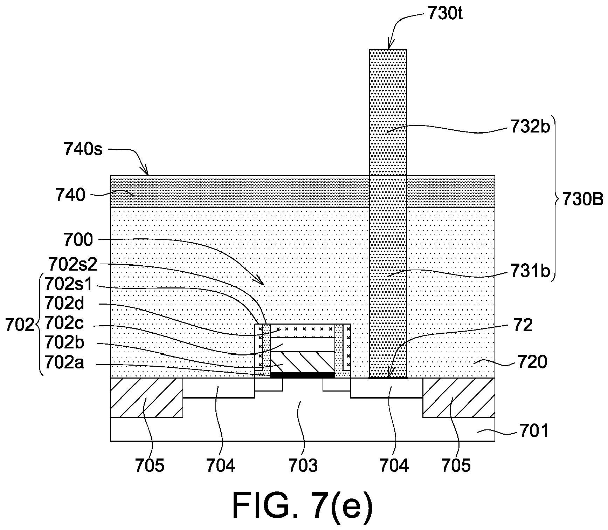

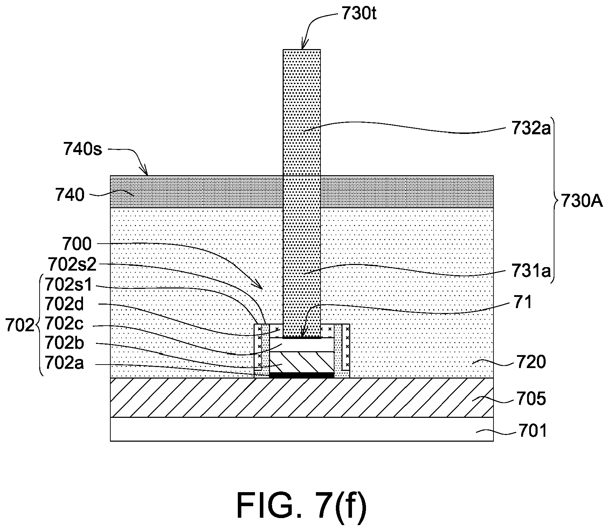

Then, as shown in FIG.7(d) to FIG.7(f), heavily doped conductive silicon plugs (or the conductor pillars) are grown by SEG based on the revealed top portion 71 and the revealed top portion 72, to form the first conductor pillar portion 731a and the third conductor pillar portion 731b. A first dielectric sub-layer 740 is then formed over the first dielectric layer 720 to make the top surface 740s of the first dielectric sub-layer 740 substantially coplanaring with the top surfaces of the first conductor pillar portion 731a and the third conductor pillar portion 731b. Those "Exposed Heads" (or the expose top surface) of the first conductor pillar portion 731a and the third conductor pillar portion 731b can be used as seed portion for the subsequent SEG process. Furthermore, each of the first conductor pillar portions 731a and the third conductor pillar portion 731b has a seed region or seed pillar in the upper portion thereof, and such seed region or seed pillar could be used for the following selective epitaxy growth. Subsequently, a second conductor pillar portion 732a is formed on the first conductor pillar 731a by a second selective epitaxy growth; and a fourth conductor pillar portion 732b is formed on the third conductor pillar portion 731b. FIG.7(d) is a top view illustrating a structure after the second conductor pillar portion 732a and the fourth conductor pillar portion 732b are formed on the first conductor pillar portions 731a and the third conductor pillar portion 731b, respectively, according to one embodiment of the present disclosure. FIG.7(e) is a cross-sectional view taken along the cutting line C7D2 as depicted in FIG.7(d). FIG.7(f) is a cross-sectional view taken along the cutting line C7D1 as depicted in FIG.7(d).

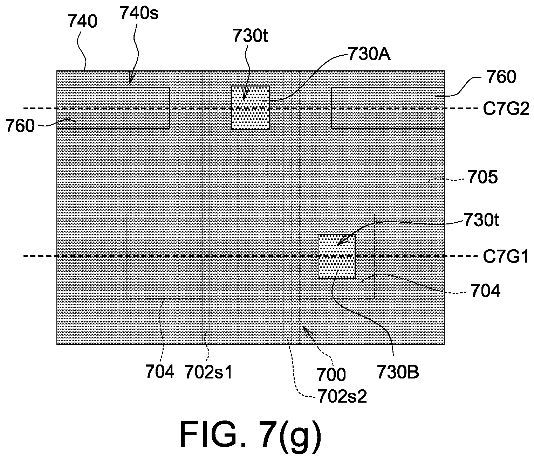

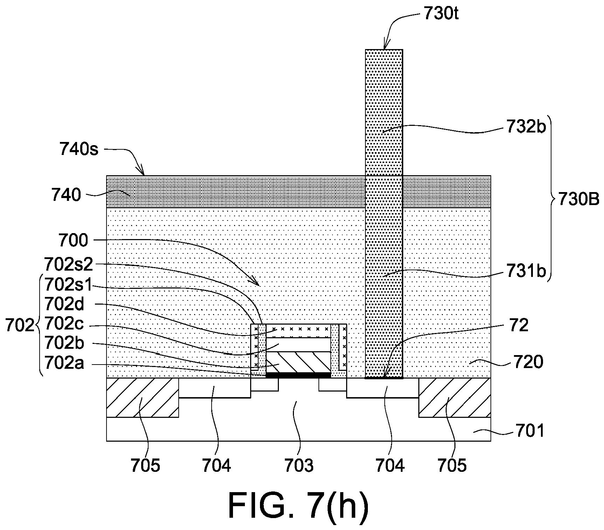

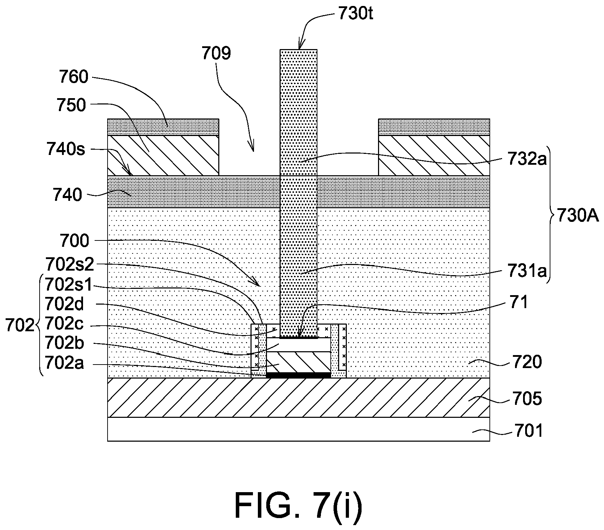

Furthermore, as shown in FIG.7(g) to FIG.7(i), a first conduction layer 750, such as copper (Cu), Aluminum (Al), tungsten (W) or other suitable conductive material, can be deposited on the top surface 740s of the first dielectric sub-layer 740. A second dielectric sub-layer 760 is then deposited on the first conduction layer 750. The first conduction layer 750 and the second dielectric sub-layer 760 are patterned to define an opening hollow 709, wherein the first conductor pillar 730A penetrates through the opening hollow 709 without contacting the first conduction layer 750 and the second dielectric sub-layer 760. FIG.7(g) is a top view illustrating a structure after the first conduction layer 750 and the second dielectric sub-layer 760 are formed over the first dielectric sub-layer 740 according to one embodiment of the present disclosure. FIG.7(h) is a cross-sectional view taken along the cutting line C7G1 as depicted in FIG.7(g). FIG.7(i) is a cross-sectional view taken along the cutting line C7G2 as depicted in FIG.7(g).

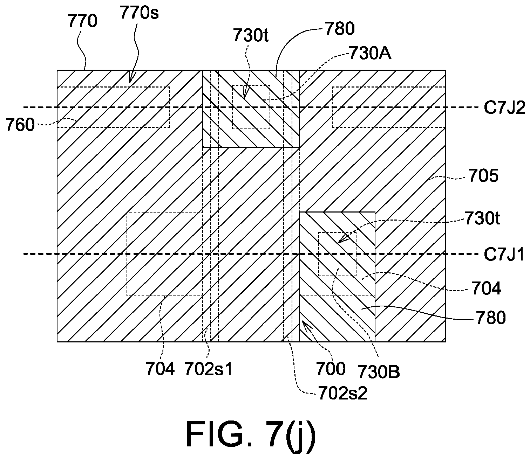

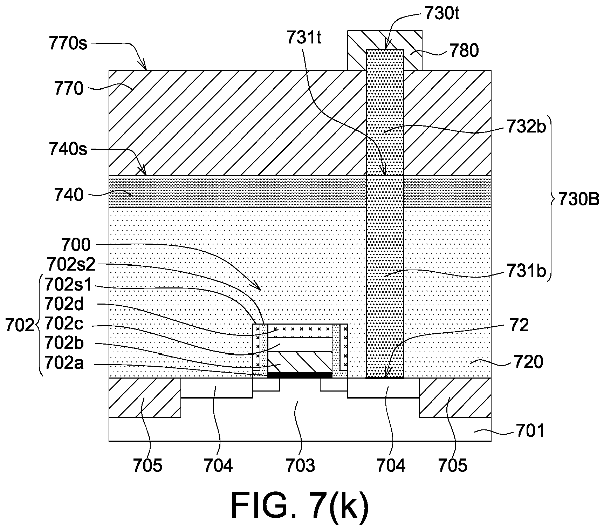

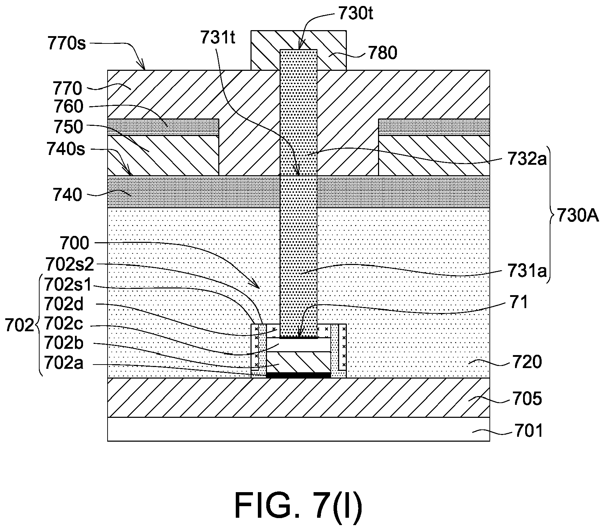

Moreover, as shown in FIGs.7(j)-7(l), the upper dielectric layer 770 is deposited to cover the second dielectric sub-layer 760 and the first dielectric sub-layer 740 to fill in the opening hollow 709. A top surface 770s of the upper dielectric layer 770 is lower than the top surface 730t of the first conductor pillar 730A (including the first conductor pillar portion or sub-pillar 731a and the second conductor pillar portion or sub-pillar 732a) and the second conductor pillar 730B (including the third conductor pillar portion or sub-pillar 731b and the fourth conductor pillar portion or sub-pillar 732b). An upper conduction layer 780 is then formed over the upper dielectric layer 770; wherein the first conductor pillar 730A connects to the upper conduction layer 780 but disconnects from the first conduction layer 750. In this example, FIG.7(j) is a top view illustrating a structure after the conduction layer 780 is formed over the over the upper dielectric layer 770 according to one embodiment of the present disclosure. FIG.7(k) is a cross-sectional view taken along the cutting line C7J1 as depicted in FIG.7(j). FIG.7(l) is a cross-sectional view taken along the cutting line C7J 2 as depicted in FIG.7(j).

As mentioned, each of the exposed silicon region 702c of the gate terminal and the exposed silicon region of the source/drain terminal has seed regions for the selective epitaxy growth technique (SEG) to grow pillars based on the seed regions. Furthermore, each of the first conductor pillar portions 731a and the third conductor pillar portion 731b also has a seed region or seed pillar in the upper portion thereof, and such seed region or seed pillar could be used for the following selective epitaxy growth. This embodiment could also be applied to allows M1 interconnection (a kind of conductive terminal) or conduction layer to be directly connected to the MX interconnection layer (without connecting to the conduction layers M2, M3,..MX-1) in a self-alignment way through one vertical conductive or conductor plug, as long as there is a seed portion or seed pillar on the upper portion of the conductive terminal and the conductor pillar portions configured for following selective epitaxy growth technique. The seed portion or seed pillar is not limited to silicon, and any material which could be used as a seed configured for following selective epitaxy growth is acceptable.

To sum up, at least there are following advantages in the new standard cell and standard cell:
(1) The linear dimensions of the source, the drain and the gate of the transistors in the standard cell are precisely controlled, and the linear dimension can be as small as the minimum feature size, Lambda (λ). Therefore, when two adjacent transistors are connected together through the drain/source, the length dimension of the transistor would be as small as 3λ, and the distance between the edges of the gates of the two adjacent transistors could be as small as 2λ. Of course, for tolerance purpose, the length dimension of the transistor would be around 3λ~6λ or larger, the distance between the edges of the gates of the two adjacent transistors could be 8λ or larger.
(2) The first metal interconnection (M1 layer) directly connect Gate, Source and/or Drain regions through self-aligned miniaturized contacts without using a conventional contact-hole-opening mask and/or an Metal-0 translation layer for M1 connections.
(3) The Gate and/or Diffusion (Source/Drain) areas are directly connected to the metal-2 (M2) interconnection layer without connecting the metal-1 layer (M1) in a self-alignment way. Therefore, the necessary space between one metal-1 layer (M1) interconnection layer and the other metal-1 layer (M1) interconnection layer and blocking issue in some wiring connections will be reduced. Furthermore, same structure could be applied to a lower metal layer is directly connected to an upper metal layer by a conductor pillar, but the conductor pillar is not electrically connected to any middle metal layer between the lower metal layer and the upper metal layer.
(4) The metal wires for high level voltage Vdd and/or the low level voltage VSS in the standard cell could be distributed under the original silicon surface of the silicon substrate, thus, the interference among the size of the contacts, among layouts of the metal wires connecting the high level voltage Vdd, and low level voltage Vss, etc. could be avoided even the size of the standard cell is shrunk. Moreover, the openings for the source/drain regions which are originally used to electrically couple the source/drain regions with metal-2 layer (M2) or metal-3 layer (M3) for Vdd or Ground connection could be omitted in the new standard cell and standard cell.

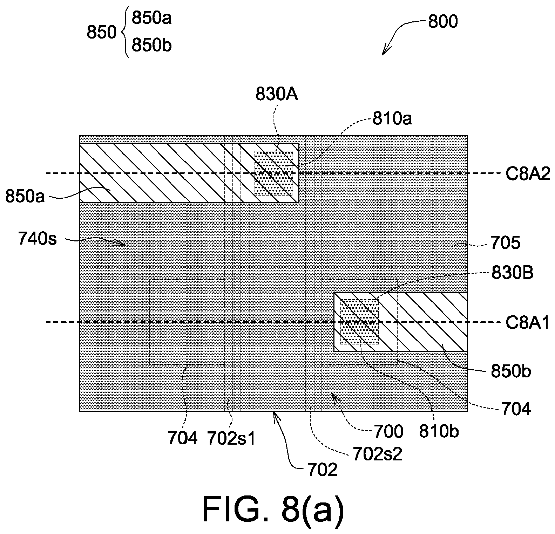

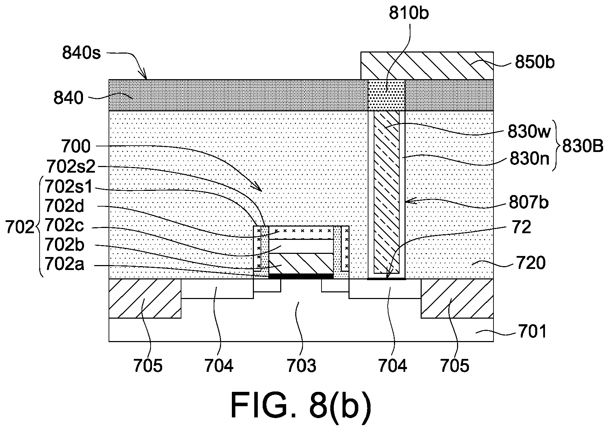

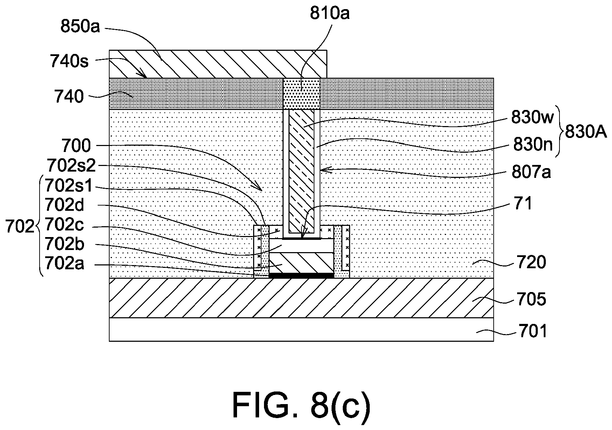

In some alternative embodiments, the conductor pillar could be a metal conductor pillar, or could be a composite conductor pillar with metal conductor pillar and a seed portion or seed pillar on the upper portion thereof. For example, FIG.8(a) is a top view of a mMOSFET 800 used in a new standard cell according one embodiment of the present disclosure. FIG.8(b) is a cross-sectional view taken along the cutting line C8A1 as depicted in FIG.8(a). FIG.8(c) is a cross-sectional view taken along the cutting line C8A2 as depicted in FIG.8(a). In the present embodiment, the conductor pillar mMOSFET 800 used for connecting the interconnection layer includes a tungsten pillars and a first highly doped silicon pillar and has a seed region or seed pillar in the upper portion thereof.

As shown in FIG.8(a) to FIG.8(c), the highly dopped N+ poly silicon pillars 731a, 732a, 731b, 732b in FIG.7(j) to FIG.7(l) could be removed and replaced by tungsten pillars 830w, the TiN layer 830n, and the highly doped silicon pillar. A first conductor pillar includes a metal pillar portion 830A (which includes tungsten pillars 830w and the TiN layer 830n) and a highly doped silicon pillar 810a; and a second conductor pillar includes a metal pillar portion 830B (which includes tungsten pillars 830w and the TiN layer 830n) and a highly doped silicon pillar 810b. The highly doped silicon pillars 810a and 810b serve as the seed region or seed pillar for growing the conductor pillars configured for connecting the following formed metal connection. For example, the highly doped silicon pillars 810a and 810b can serve as the seed region or seed pillar of the following SEG processes to grow another silicon pillars thereon to connect the first conduction layer 850 (such as a first metal sub-layer 850a or a second metal sub-layer 850b) that is formed over the first dielectric sub-layer 840 and electrically connected to the highly doped silicon pillars 810a and 810b. The conductor pillar could have a seed region or seed pillar in the upper portion thereof, a borderless contact is fulfilled since the highly doped silicon pillars 810a and 810b are the seed region or seed pillar of the conductor pillar configured for following SEG processes to grow another silicon pillars thereon.

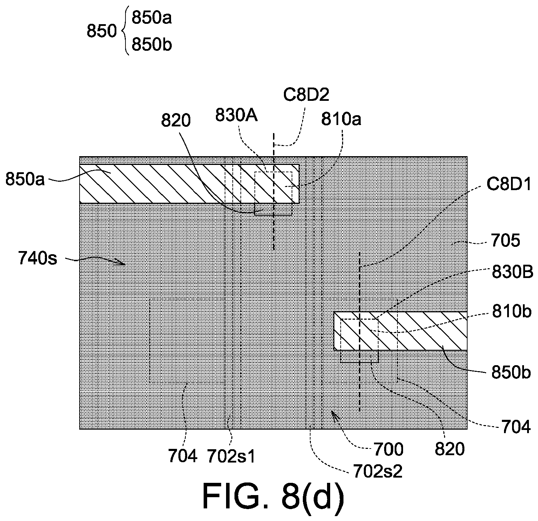

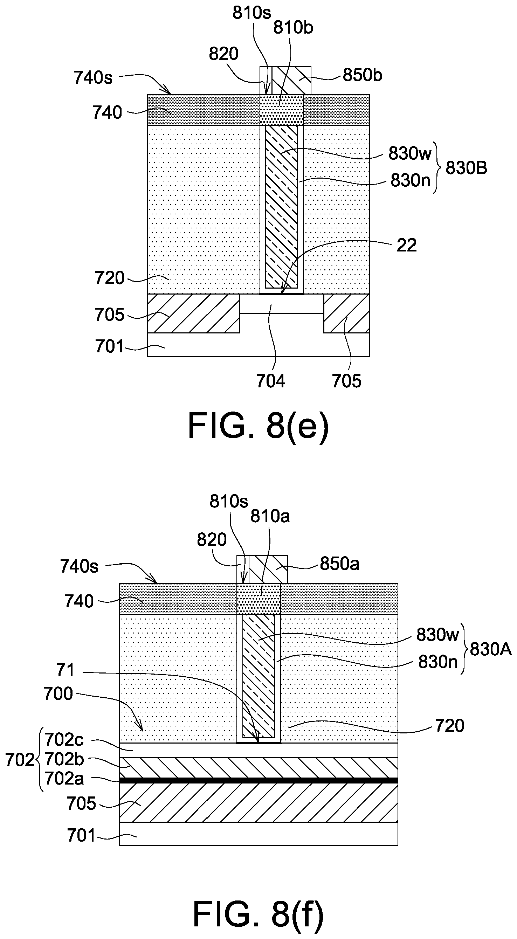

In some embodiment, a width of the metal contacting line (such as the first metal sub-layer 850a or 850b) could be the same or substantially the same as that of the contact (such as the highly doped silicon pillars 810a or the highly doped silicon pillar 810b). Of course, the width of the metal contacting line could be different from that of the first contact. As shown in FIG.8(d) to FIG.8(f), even if the width of the metal conduction line (such as, the first metal sub-layer 850a or the second metal sub-layer 850b) is not the same as that of the underneath contact plug (which may be as small as minimum feature size of the highly doped silicon pillars 810a or 810b). However, there is misalignment between the metal conduction line and the underneath contact plug, the photolithographic masking misalignment tolerance can cause that the metal conduction line (such as, the first metal sub-layer 850a or the second metal sub-layer 850b) cannot fully cover the contact (such as the highly doped silicon pillars 810a or 810b, as shown in FIG.8(e) and FIG.8(f)), though there is no worry about the resistance between the metal conduction layer and contact may be too high due to shortages of contact areas.

Thus the resistance between the metal conduction line and the underneath contact may be well-controlled. The invention here uses SEG to grow some extra highly doped silicon material connecting both the metal conduction line and the underneath contact plug to improve the resistance issue incurred by misalignment between the metal conduction line and the underneath contact plug. In the present embodiment, a further SEG process is performed to grow some extra highly doped silicon material (side pillars 820) to attach the vertical walls of the metal conduction layers 850a and 850b. FIG.8(d) is a top view of another mMOSFET 800' used in a new standard cell according to another embodiment of the present disclosure, FIG.8(e) is a cross-sectional view taken along the cutting line C8D1 as depicted in FIG. 8(d). FIG.8(f) is a cross-sectional view taken along the cutting line C8D2 as depicted in FIG.8(d).

The conventional standard cell may not allow the gate or source/drain directly connect to Metal-2 layers (M2) without bypassing the Metal-1 layers (M1). The present invention discloses a new standard cell structure in which the gate/source/drain could be directly connected to the Metal-2 interconnection layer (M2) without a transitional Metal-1 layer (M1) in a self-alignment way through one vertical conductive plug. The detailed description regarding Gate area/active region directly connected to the Metal-2 interconnection layer (M2) is presented in the U.S. Patent Application No. 17/528,957, filed on November 17, 2021 and entitled " INTERCONNECTION STRUCTURE AND MANUFACTURE METHOD THEREOF", and the whole content of the U.S. Patent Application No. 17/528,957 is incorporated by reference herein.

Additionally, the present invention discloses a new MOS structure in which the source and drain regions are fully isolated by insulators, such insulators would not only increase the immunity to the latch-up issue, but also increase the isolation distance into silicon substrate to separate junctions in adjacent transistors so that the surface distance between junctions can be decreased (such as 3λ), so is the size of the standard cell. The following briefly describes a new CMOS structure in which the n+ and p+ regions of the source and drain regions in the NMOS and PMOS transistors respectively are fully isolated by insulators.

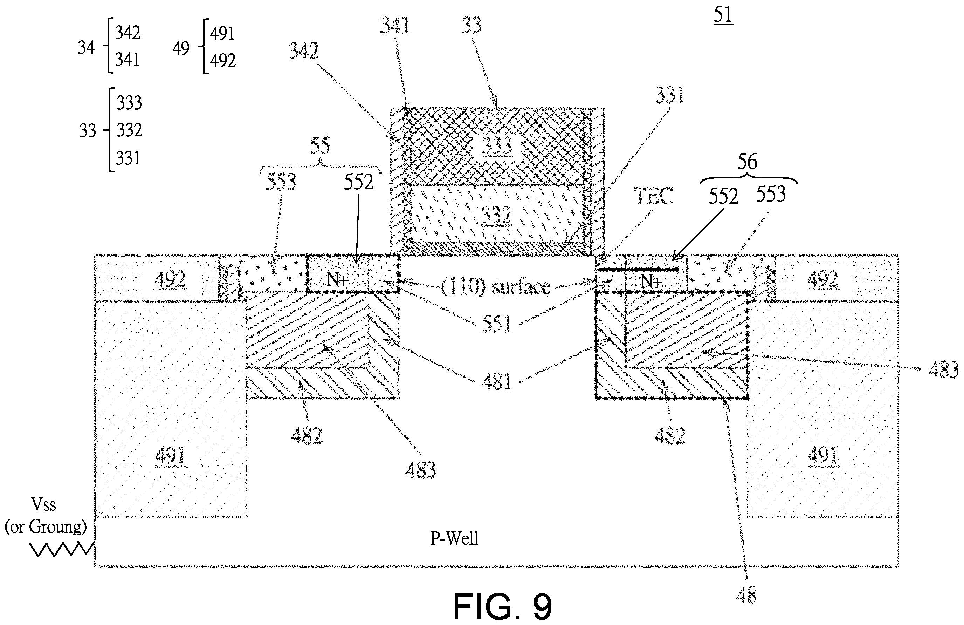

Please refer to FIG.9, FIG.9 is a diagram illustrating a cross section of the NMOS transistor 51 used in a new standard cell according to another embodiment of the present disclosure. The gate structure 33 comprising a gate dielectric layer 331 and gate conductive layer 332 (such as gate metal) is formed above the horizontal surface or original surface of the semiconductor substrate (such as silicon substrate). A dielectric cap 333 (such as a composite of oxide layer and a Nitride layer) is over the gate conductive layer 332. Furthermore, spacers 34 which may include a composite of an oxide layer 341 and a Nitride layer 342 is used to over sidewalls of the gate structure 33. Trenches are formed in the silicon substrate, and all or at least part of the source region 55 and drain region 56 are positioned in the corresponding trenches, respectively. The source (or drain) region in the MOS transistor 52 may include N+ region or other suitable doping profile regions (such as gradual or stepwise change from P- region and P+ region).

Furthermore, a localized isolation 48 (such as nitride or other high-k dielectric material) is located in one trench and positioned under the source region, and another localized isolation 48 is located in another trench and positioned under the drain region. Such localized isolation 48 is below the horizontal silicon surface (HSS) of the silicon substrate and could be called as localized isolation into silicon substrate (LISS) 48. The LISS 48 could be a thick Nitride layer or a composite of dielectric layers. For example, the localized isolation or LISS 48 could comprise a composite localized isolation which includes an oxide layer (called Oxide-3V layer 481) covering at least a portion sidewall of the trench and another oxide layer (Oxide-3B layer 482) covering at least a portion bottom wall of the trench. The Oxide-3V layer 481 and Oxide-3B layer 482 could be formed by thermal oxidation process.

The composite localized isolation 48 further includes a nitride layer 483 (called as Nitride-3) being over the Oxide-3B layer 482 and contacting with the Oxide-3V layer 481. It is mentioned that the nitride layer 483 or Nitride-3 could be replaced by any suitable insulation materials as long as the Oxide-3V layer remains most as well as being designed. Furthermore, the STI (Shallow Trench Isolation) region in FIG.9 could comprises a composite STI 49 which includes a STI-1 layer 491 and a STI-2 layer 492, wherein the STI-1 layer 491 and a STI-2 layer 492 could be made of thick oxide material by different process, respectively.

Moreover, the source (or drain) region in FIG.9 could comprise a composite source region 55 and/or drain region 56. For example, in the NMOS transistor 52, the composite source region 55 (or drain region 56) at least comprises a lightly doped drain (LDD) 551 and an N+ heavily doped region 552 in the trench. Especially, it is noted that the lightly doped drain (LDD) 551 abuts against an exposed silicon surface with a uniform (110) crystalline orientation. The exposed silicon surface has its vertical boundary with a suitable recessed thickness in contrast to the edge of the gate structure, which is labeled in FIG.9 as TEC (Thickness of Etched-away Transistor-body Well-Defined to be the Sharp Edge of Effective Channel Length). The exposed silicon surface is substantially aligned with the gate structure. The exposed silicon surface could be a terminal face of the channel of the transistor.

The lightly doped drain (LDD) 551 and the N+ heavily doped region 552 could be formed based on a Selective Epitaxial Growth (SEG) technique (or other suitable technology which may be Atomic Layer Deposition ALD or selective growth ALD - SALD) to grow silicon from the exposed TEC area which is used as crystalline seeds to form new well-organized (110) lattice across the LISS region which has no seeding effect on changing (110) crystalline structures of newly formed crystals of the composite source region 55 or drain region 56. Such newly formed crystals (including the lightly doped drain (LDD) 551 and the N+ heavily doped region 552) could be named as TEC-Si, as marked in FIG.9.

In one embodiment, the TEC is aligned or substantially aligned with the edge of the gate structure 33, and the length of the LDD 551 is adjustable, and the sidewall of the LDD 551 opposite to the TEC could be aligned or substantially aligned with the sidewall of the spacer 34. The composite source (or drain) region could further comprise some Tungsten (or other suitable metal materials) plugs 553 formed in a horizontal connection to the TEC-Si portion for completion of the entire source/drain regions. As shown in FIG.9 the active channel current flowing to future Metal interconnection such as Metal-1 layer is gone through the LDD 551 and the N+ heavily-doped region 552 to Tungsten 553 (or other metal materials) which is directly connected to Metal-1 by some good Metal-to-Metal Ohmic contact with much lower resistance than the traditional Silicon-to-Metal contact.

The source/drain contact resistance of the NMOS transistor 52 can be kept for a reasonable range according to the structure of the merged metal-semiconductor junction utilized in the source/drain structure, as shown in FIG.9. This merged metal-semiconductor junction in the source/drain structure can improve current crowding effect and reduce contact resistance. Additionally, because the bottom of source/drain structure is isolated from the substrate due to the bottom oxide (Oxide-3B layer 482) (shown in FIG.9), the n+ to n+ or p+ to p+ isolation can be kept within a reasonable range. Therefore, the spacing between two adjacent active regions of the PMOS transistor (not shown) could be scaled down to 2λ. The bottom oxide (Oxide-3B layer 482) can significantly reduce source/drain junction leakage current and then reduces n+ to n+ or p+ to p+ leakage current.

Furthermore, in currently available standard cell, the metal wires for high level voltage Vdd and low level voltage Vss (or Ground) are distributed above the original silicon surface of the silicon substrate, and such distribution will interfere with other metal wires if there no enough spaces among those metal wires. The present invention discloses a new standard cell in which the metal wires for high level voltage Vdd and/or the low level voltage Vss could be distributed under the original silicon surface of the silicon substrate, thus, the interference among the size of the contacts, among layouts of the metal wires connecting the high level voltage Vdd, and low level voltage Vss, etc. could be avoided even the size of the standard cell is shrunk.

As shown in FIG.9, in the drain region of the NMOS 51, the Tungsten or other metal materials 553 is directly coupled to the P-well which is electrically coupled to Vdd. On the other hand, in the source region of the NMOS 51, the Tungsten or other metal materials 553 is directly coupled to the p-well or P-substrate which is electrically coupled to Ground. Thus, the openings for the source/drain regions which are originally used to electrically couple the source/drain regions with metal-2 layer (M2) or metal-3 layer (M3) for Vdd or Ground connection could be omitted in the new standard cell and standard cell. The detailed description for the structure of the aforesaid structure and the manufacture process thereof is presented in the US Patent Application No. 16/991,044, filed on Aug. 12, 2020 and entitled: "TRANSISTOR STRUCTURE AND RELATED INVERTER", and the whole content of the US Patent Application No. 16/991,044 is incorporated by reference herein.

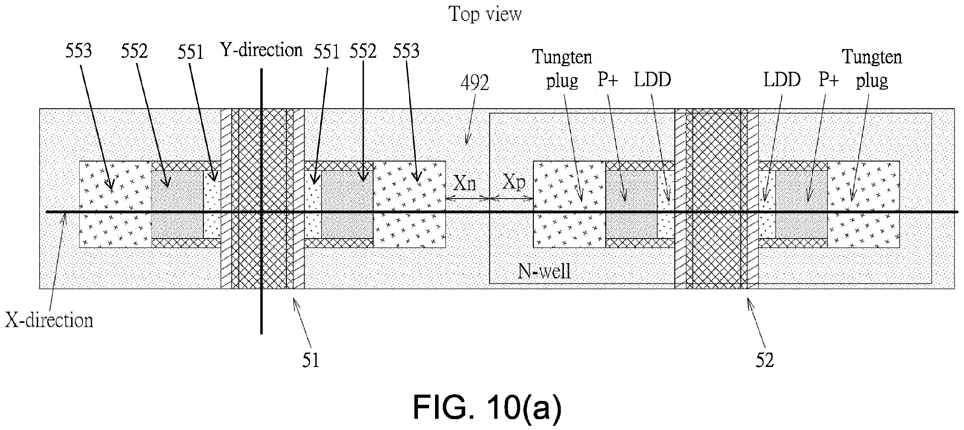

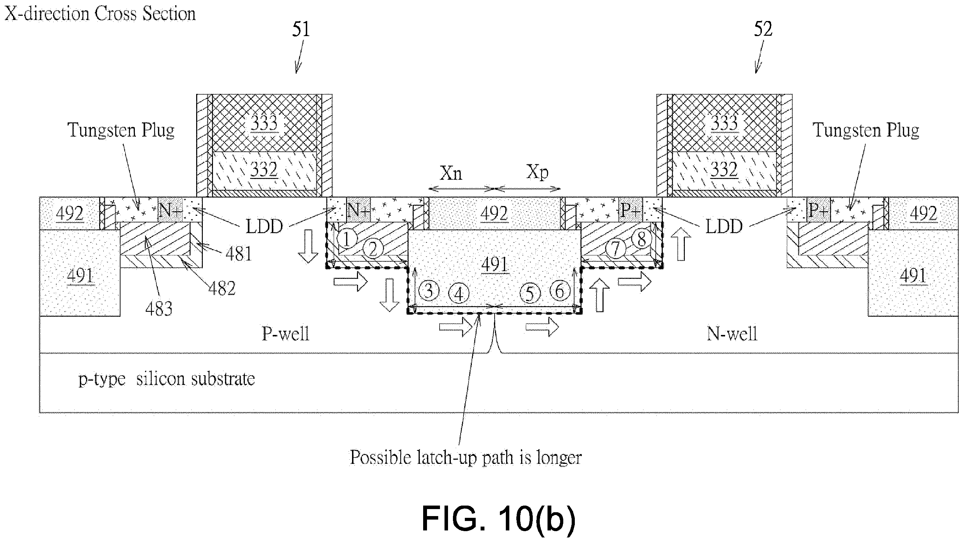

FIG.10(a) is a top view illustrating a combination structure of the PMOS transistor 52 and the NMOS transistor 51 used in a new standard cell according to one embodiment of the present embodiment. FIG. 10(b) is a cross-sectional view of the PMOS transistor 52 and the NMOS transistor 51 taking along the cutline (X-axis) in FIG.10(a). As shown in FIG.10(b), it results in a much longer path from the n+/p junction through the p-well (or p-substrate)/n-well junction to the n/p+ junction. The possible Latch-up path from the LDD-n/p junction through the p-well /n-well junction to the n/LDD-p junction includes the length ①, the length ② (the length of the bottom wall of one LISS region), the length ③, the length ④, the length ⑤, the length ⑥, the length ⑦ (the length of the bottom wall of another LISS region), and the length ⑧ marked in FIG.10(b). On the other hand, in traditional CMOS structure which combines the PMOS transistor 12 and NMOS transistor 11 shown in FIG. 2, the possible Latch-up path from the n+/p junction through the p-well/n-well junction to the n/p+ junction just includes the length (d), the length (e), the length (f), and the length (g) (as shown in FIG.2). Such possible Latch-up path of FIG.10(b) is longer than that in FIG.2. Therefore, from device layout point of view, the reserved edge distance (Xₙ+Xₚ) between the PMOS transistor 52 and the NMOS transistor 51 in FIG.10(b) could be smaller than that in FIG. 2. For example, the reserved edge distance (Xₙ+Xₚ) could be around 2~4λ, such as 3λ.

Furthermore, unlike the above-mentioned conventional standard cell, the present invention utilized cross-shape Localized Isolation into Silicon Substrate (LISS) (e.g. Nitride-3+Oxide-3) between the PMOS transistor 52 and the NMOS transistor 51 of the standard cell, such that the possible latch-up path between the PMOS transistor 52 and the NMOS transistor 51 could be longer than that in a conventional CMOS, and the latch-up distance or the reserved edge distance between the PMOS transistor 52 and the NMOS transistor 51 could be shorter than that used in conventional standard cell.

Therefore, the latch-up distance between the PMOS transistor 52 and the NMOS transistor 51 in the present invention is as small as 8λ, no matter the size of the technology node or (or minimum feature size). In the present invention, the n+ and p+ regions of the source and drain regions in the NMOS and PMOS transistors respectively are fully isolated by insulators, such insulators would not only increase the immunity to Latch-up issue, but also increase the isolation distance into silicon substrate to separate junctions in PMOS transistor 52 and the NMOS transistor 51 so that the surface distance between junctions can be decreased. The detailed description for the new combination structure of the PMOS and MNOS is presented in the US Patent Application No. 17/318,097, field on May 12, 2021 and entitled "COMPLEMENTARY MOSFET STRUCTURE WITH LOCALIZED ISOLATIONS IN SILICON SUBSTRATE TO REDUCE LEAKAGES AND PREVENT LATCH-UP", and the whole content of the US Patent Application No. 17/318,097 is incorporated by reference herein.

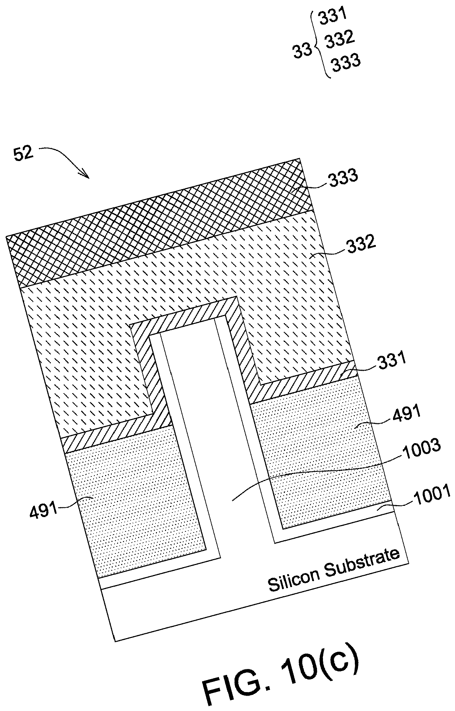

To solve small I-on current issue when the source/drain contact size is shrunk, the present invention here could further use selective epitaxy growth (SEG) technology to grow a thin channel layer 1001 covering the original body of the active regions (such as a fin structure1003) under the gate structure 33 of the PMOS transistor 52 (or the NMOS transistor 51) to enhance the electron/hole mobility. For example, FIG.10(c) is a cross-sectional view of the PMOS transistor 52 and the NMOS transistor 51 taking along the cutline (Y-axis) in FIG.10(a). The thin channel layer 1001 is a doped channel layer formed without applying an ion implantation. Furthermore, the thin channel layer 1001 is not part of the original silicon substrate, thus, the thin channel layer 1001 is independent from the semiconductor substrate. Moreover, in one embodiment, the thin channel layer 1001 covers a first sidewall and a second sidewall of the fin structure 1003 and does not cover a top surface of the fin structure 1003. In another embodiment, the thin channel layer 1001 comprises a top portion (not shown) covering a top surface of the fin structure 1003 and a side portion covering a first sidewall and a second sidewall of the fin structure, and the top portion and the side portion are not simultaneously formed. The detailed description for the improved I-on current of the transistors is presented in the US Provisional Application No. 63/226,787, field on July 29, 2021 and entitled "New Transistor Structure and Processing Method Thereof", and the whole content of the US Provisional Application No. 63/226,787 is incorporated by reference herein.

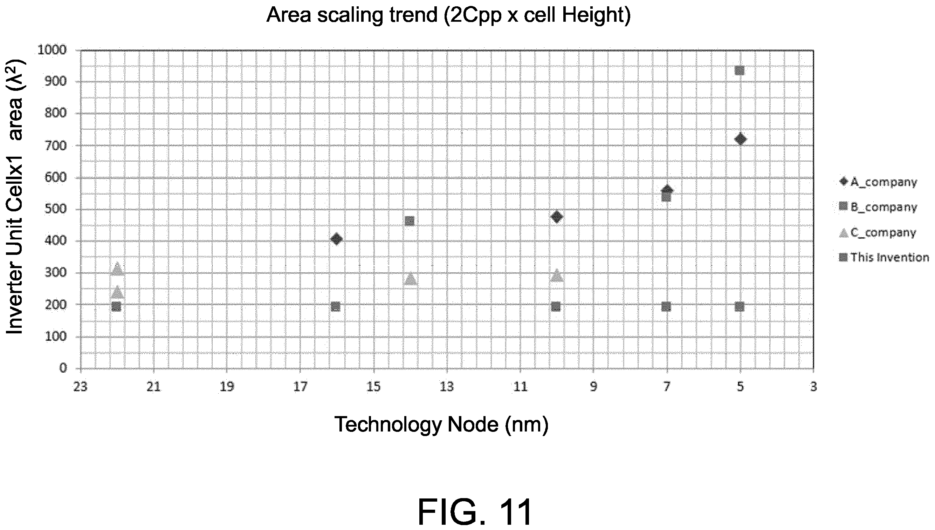

According to the above-mentioned, the standard cell in which an inverter is accommodated (such as the new inverter standard cell 500 as shown in FIG. 5(a) and FIG.5(b)) has area size (2xCppxCell_Height) of 192λ² in the new invention structure, and such area size in terms of λ² will almost be the same at least from technology node 22nm down to 5nm in comparison with the conventional products provided by various companies (such as the A_company, the B_company and the C_company) as shown in FIG.11. FIG.11 is a diagram illustrating the comparison result among the area size of the new standard cell provided by the preset invention and that of the conventional products provided by various other companies.

However, the layout styles and the area size of the new standard cell are not limited to these regards. In some other embodiments, the present invention could be utilized in various standard cells (such as the standard cells with one-single NOR cell, one-single NAND cell, NOR cellx2 or NAND cellx2) with different layout styles and cell sizes (such as 3xCppxCell_Height, or 5xCppxCell_Height).

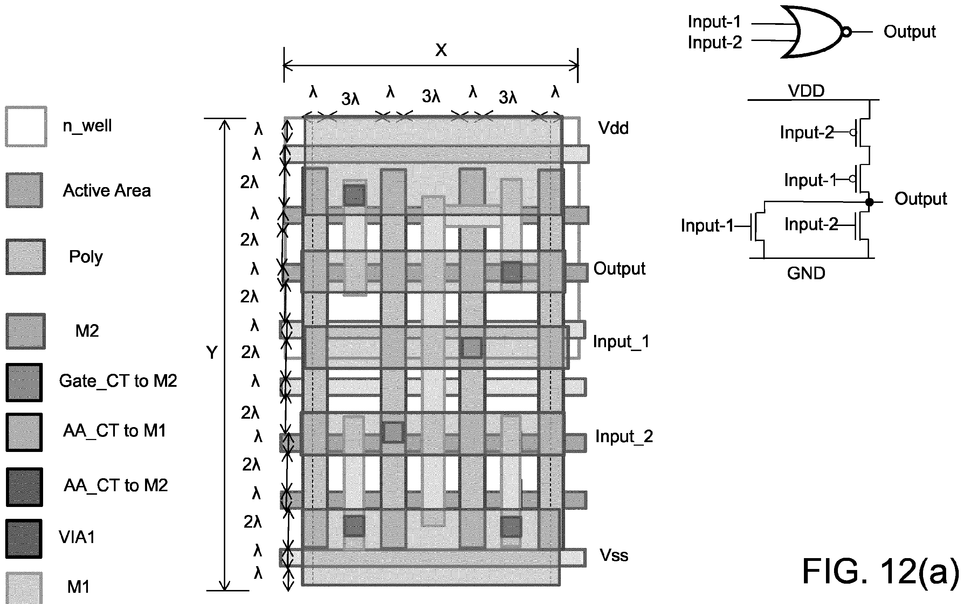

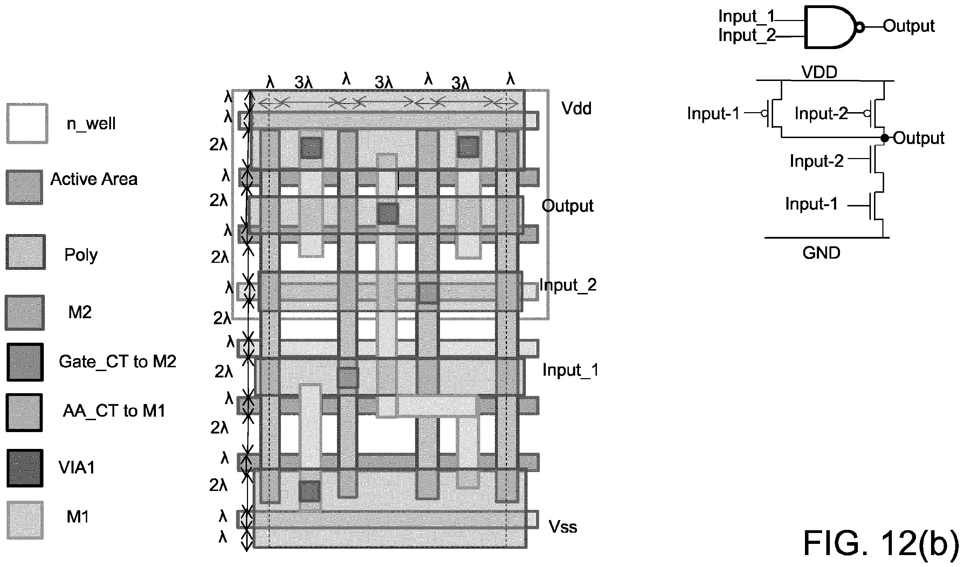

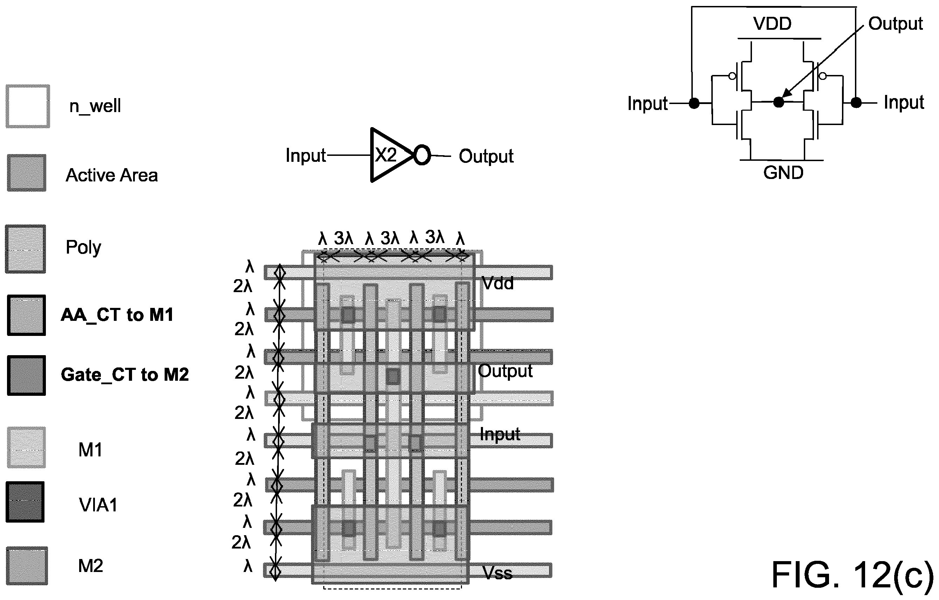

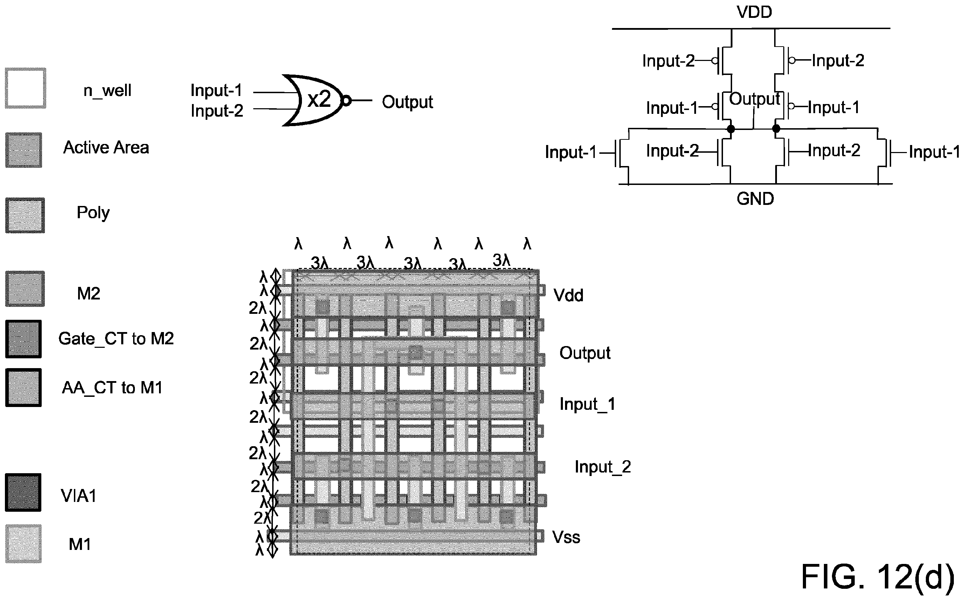

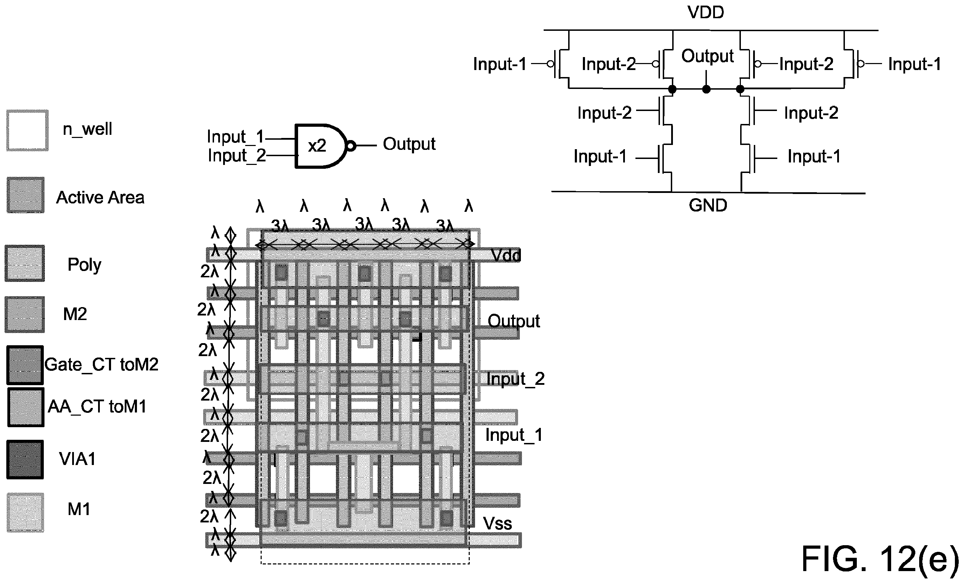

For example, FIG.12(a) to FIG.12(c) are top views and the corresponding equivalent circuit diagrams of the standard cells with one-single NOR cell, one-single NAND cell and Inverter cellx2 according to some embodiments of the present disclosure. FIG.12(d) and FIG.12(e) are top views and the corresponding equivalent circuit diagrams of the standard cells with NOR cellx2 and NAND cellx2 according to some embodiments of the present disclosure. Wherein the standard cells with one-single NOR cell, one-single NAND cell and Inverter cellx2 may have the cell size of 3xCppxCell_Height; and the standard cells with NOR cellx2 and NAND cellx2 may have the cell size of 5xCppx Cell_Height.

This invention develops a compact layout style in a new standard cell design. In some embodiment of the present disclosure, the new compact layout style can enable the standard cell has an area size of λ² which can be independent from the technology scaling in term of λ (Lambda is the minimum feature of size of the technology node). With the layout design described in this document, the area size of the standard cell across different technology nodes can stay flat or less sensitive to the technology nodes. In addition, the Latch-up issue is not enlarged as the size of the standard cell scaling down.

While the invention has been described by way of example and in terms of the preferred embodiment (s), it is to be understood that the invention is not limited thereto. On the contrary, it is intended to cover various modifications and similar arrangements and procedures, and the scope of the appended claims therefore should be accorded the broadest interpretation so as to encompass all such modifications and similar arrangements and procedures.

## Claims

1. A standard cell, comprising:
a plurality of transistors;
a set of contacts, coupled to the plurality of transistors;
at least one input line, electrically coupled to the plurality of transistors;
an output line, electrically coupled to the plurality of transistors;
a VDD contacting line, electrically coupled to the plurality of transistors; and
a VSS contacting line, electrically coupled to the plurality of transistors;
wherein as a minimum feature size (λ) of the standard cell gradually decreases
for different technology nodes, an area size of the standard cell in terms of λ² is the same or substantially the same.

2. The standard cell according to claim 1, wherein the standard cell is an inverter cell, a NAND cell, or a NOR cell.

3. The standard cell according to claim 1 or 2, further comprising:
a metal contacting line electrically coupled to a first contact of the set of contacts; wherein the first contact is not fully covered by the metal contacting line.

4. The standard cell according to claim 3, wherein a width of the metal contacting line is the same or substantially the same as that of the first contact.

5. The standard cell according to claim 3 or 4, further comprising a highly doped silicon plug formed on a portion of the first contact which is not covered by the metal contacting line, wherein the highly doped silicon plug contacts to the metal contacting line.

6. The standard cell according to anyone of the claims 1 to 5, further comprising:
a first metal line, electrically coupled to the plurality of transistors; and
a second metal line, electrically coupled to the plurality of transistors, wherein the second metal line is above the first metal line;
wherein at least one of the set of contacts directly connects to the second metal line without though the first metal line.

7. The standard cell according to claim 6, wherein the at least one of the set of contacts is a gate contact.

8. A standard cell comprising:
a semiconductor substrate with an original surface;
a plurality of transistors;
a set of contacts, coupled to the plurality of transistors;
a first metal line, electrically coupled to the plurality of transistors; and
a second metal line, electrically coupled to the plurality of transistors;
wherein the plurality of transistors are formed based on the semiconductor substrate, at least one of the plurality of transistors comprises a channel layer and a conductive region;
wherein the channel layer or the conductive region is independent from the semiconductor substrate and is doped without applying an ion implantation.

9. The standard cell according to claim 8, wherein the at least one transistor comprises a fin structure, the channel layer covers a first sidewall and a second sidewall of the fin structure and does not cover a top surface of the fin structure.

10. The standard cell according to claim 8, wherein the at least one transistor comprises a fin structure, the channel layer comprises a top portion covering a top surface of the fin structure and a side portion covering a first sidewall and a second sidewall of the fin structure, and the top portion and the side portion are not simultaneously formed.

11. The standard cell according to anyone of the claims 8 to 10, wherein the conductive region is selectively grown based on a side edge of the semiconductor substrate.

12. The standard cell according to claim 11, further comprising:
a trench formed under the original surface of the semiconductor substrate; and
an isolation region in the trench, wherein the conductive region is disposed in the trench, and a bottom surface of the conductive region is isolated from the semiconductor substrate by the isolation region.

13. The standard cell according to claim 12, wherein only one side of the conductive region is contacted to the semiconductor substrate.

14. The standard cell according to claim 12 or 13, further comprising:
a metal region contacting the conductive region, wherein the metal region is disposed in the trench, and a bottom surface of the metal region is isolated from the semiconductor substrate by the isolation region.

15. A standard cell, comprising:
a substrate with a well region;
a plurality of transistors including a first type transistor and a second transistor, wherein the first type transistor is formed within the well region and the second type transistor is formed outside the well region;
a plurality of contacts, coupled to the plurality of transistors;
at least one input line, electrically coupled to the plurality of transistors;
an output line, electrically coupled to the plurality of transistors;
a VDD contacting line, electrically coupled to the plurality of transistors; and
a VSS contacting line, electrically coupled to the plurality of transistors;
wherein the first type transistor includes a first set of fin structures electrically coupled together, the second type transistor includes a second set of fin structures electrically coupled together, and a gap between the first type transistor and the second type transistor is equal to or substantially equal to 3xFp-Fw, wherein Fp is a fin pitch distance between two adjacent fin structures in the first type transistor and Fw is the fin width of the fin structure;
wherein the fin pitch distance between the two adjacent fin structures in the first type transistor is between 3~5λ, λ is a minimum feature size.

16. The standard cell according to claim 15, wherein the gap between the first type transistor and the second type transistor is between 8~12λ.

17. A standard cell, comprising:
a plurality of transistors;
a set of contacts, coupled to the plurality of transistors;
a first metal line, electrically coupled to the plurality of transistors; and
a second metal line, electrically coupled to the plurality of transistors, wherein the second metal line is above the first metal line;
wherein at least one of the set of contacts directly connects to the second metal line without though the first metal line.

18. The standard cell according to claim 17, wherein the at least one of the set of contacts is a gate contact.
